# EUROPEAN PATENT SPECIFICATION

(11) **EP 3 495 887 B1**
(45) Date of publication and mention of the grant of the patent: **22.09.2021**
(21) Application number: 17855469.7
(22) Date of filing: 18.08.2017
(51) Int. Cl.: B41C 1/10

(54) **POSITIVE TYPE PLANOGRAPHIC PRINTING PLATE PRECURSOR AND METHOD OF PRODUCING PLANOGRAPHIC PRINTING PLATE**
POSITIV ARBEITENDER PLANOGRAFISCHER DRUCKPLATTENVORLÄUFER UND VERFAHREN ZUR HERSTELLUNG EINER PLANOGRAFISCHEN DRUCKPLATTE
PRÉCURSEUR DE PLAQUE D'IMPRESSION PLANOGRAPHIQUE POSITIVE ET PROCÉDÉ POUR PRODUIRE UNE PLAQUE D'IMPRESSION PLANOGRAPHIQUE

(30) Priority: 29.09.2016 JP 2016192049
(43) Date of publication of application: 12.06.2019
(73) Proprietor: FUJIFILM Corporation, Tokyo 106-8620 (JP)
(72) Inventor: YASUHARA, Yuichi, Haibara-gun Shizuoka 421-0396 (JP); NOZAKI, Atsuyasu, Haibara-gun Shizuoka 421-0396 (JP)
(74) Representative: Hoffmann Eitle
(86) International application number: PCT/JP2017/029660
(87) International publication number: WO 2018/061511

(56) References cited:
- EP-A1- 1 627 732
- EP-A1- 2 080 616
- EP-A1- 2 933 278
- EP-A1- 2 963 496
- EP-A2- 2 106 907
- WO-A1-2016/047392
- JP-A- H11 327 129
- JP-A- 2005 099 138
- JP-A- 2005 106 910
- JP-A- 2013 047 782

## Description

### BACKGROUND OF THE INVENTION

### 1. Field of the Invention

The present disclosure relates to a positive type planographic printing plate precursor and a method of producing a planographic printing plate.

### 2. Description of the Related Art

In recent years, lasers in the field of planographic printing have been remarkably developed, and in particular, solid-state lasers and semiconductor lasers having an emission region from a near infrared region to an infrared region, with a high output and a small size, have become easily available. In the field of planographic printing, as an exposure light source at the time of plate-making directly from digital data such as a computer, these lasers are very useful.

A positive type planographic printing plate precursor for an infrared laser has an alkali-soluble binder resin and, for example, an infrared absorbent (for example, an infrared absorbing dye (IR dye)) which absorb light and generate heat, as indispensable components. In the unexposed portion (image area), this IR dye act as a development restrainer which substantially decreases the solubility of a binder resin in a developer due to an interaction between the IR dye and the binder resin, and in the exposed portion (non-image area), the interaction between the IR dye and the binder resin weakens due to generated heat, the IR dye are dissolved in an alkaline developer, and as a result, a planographic printing plate is formed.

### SUMMARY OF THE INVENTION

Since the image forming capability of a positive type planographic printing plate precursor for an infrared laser as described above depends on the heat generated by a surface of an image recording layer being exposed to an infrared laser, in the vicinity of a support, an image is formed by diffusion of heat to the support, that is, the heat quantity to be used for solubilization of the image recording layer is reduced, and thus, the sensitivity becomes low. Therefore, there is a problem in that development restraining capability loss effects of the recording layer in the non-image area are not sufficiently obtained, a difference between the image area and the non-image area is reduced, and thus, highlight reproducibility is insufficient.

To solve the above-described problem of the highlight reproducibility, using a recording layer formed of a material having characteristics in which a non-image area can be more easily developed, that is, the solubility in an alkali aqueous solution is excellent may be considered, but there is a problem in that such a recording layer becomes chemically weakened even in the image area region and easily damaged by the developer, an ink washing solvent used during printing, or the plate cleaner, which means that the chemical resistance deteriorates. Further, there is demand for a resin material having characteristics in which the chemical resistance and the durability of a coated film in the unexposed portion region are excellent and the developability thereof is excellent after the dissolution suppressing action is released due to exposure.

Various improved techniques have been suggested for the same purpose as described above. For example, EP-B-1826001, EP-A-2 106 907 and EP-A-2 080 616 describe a thermosensitive positive type planographic printing plate precursor which includes a support having a hydrophilic surface or a hydrophilic layer, and a thermosensitive layer containing an infrared absorbent, a phenol resin, and an alkali-soluble resin having a monomer unit of Formula I or II.

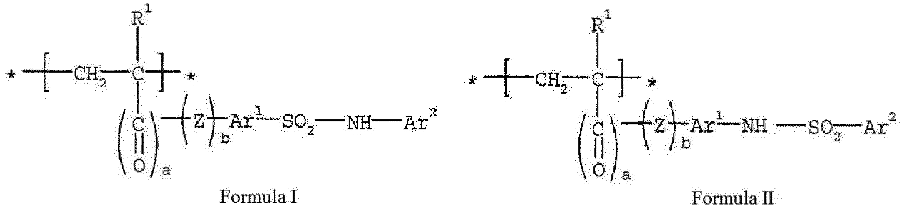

Further, WO 2014/106554 and EP-A-2 933 278 describe a planographic printing plate precursor which contains a copolymer having a structure of Formula III and a structure of Formula IV and the above-described copolymer. A planographic printing plate precursor which contains a copolymer having a structure of Formula IV is also described in EP-A-2 963 496.

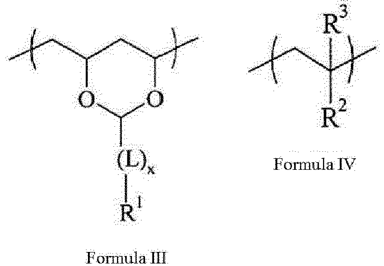

WO 2016/133072 describes a photosensitive resin composition which contains a polymer compound having a polycyclic structure in the main chain and containing a sulfonamide group in the main chain, and an infrared absorbent.

In recent years, diversification of print materials (e.g. paper and ink) has progressed, and even in a case of using the same printing plate, there is a problem in that the number of printable sheets (hereinafter, referred to as "printing durability") is greatly reduced depending on the type of a print material.

In the invention described in EP-B-1826001 and the invention described in WO 2014/106554, high chemical resistance is obtained by using a polymer compound to which a unit with high chemical resistance has been introduced as one binder resin. However, since the strength of the image recording layer itself is weak, there is a problem in that the printing durability and the chemical resistance in printing are degraded in a case where a particularly low-quality print material (paper or ink) is used.

Further, WO 2016/133072 describes a planographic printing plate precursor which contains a sulfonamide group and a polycyclic structure in the main chain and thus the printing durability and the chemical resistance become excellent. However, with the diversification of the above-described print materials, further improvement of printing durability and chemical resistance has been demanded.

EP-A-1 627 732 discloses a positive planographic printing plate precursor, comprising a substrate and, disposed on the substrate, a recording layer contains a polymer compound of formula (I), 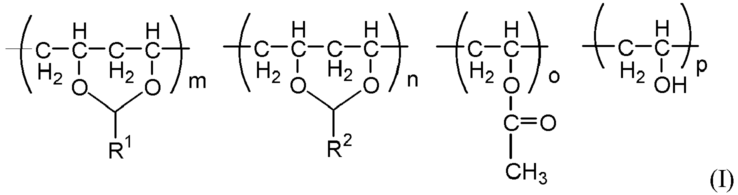 wherein R¹ is a hydrocarbon group and R² is an aromatic group having a hydroxyl group, m = 5-40 mol%, n = 10-60 mol%, o = 1-20 mol% and p = 5-50 mol%; an onium salt of the formula M+X- (A) wherein M+ is sulfonium or iodonium cation X- is a counter anion; an infrared absorber and a novolac resin.

Further, the present inventors found that there is a problem in that stains are generated on a printed material formed using a planographic printing plate to be obtained in a case where the planographic printing plate is prepared by exposing a positive type planographic printing plate precursor and developing the resulting precursor after a lapse of time.

It is speculated that the problem is caused because an interaction between an alkali-soluble resin and a low-molecular component such as an infrared absorbent in the image recording layer is recovered after exposure and this results in degradation of the developability.

In the present disclosure, the suppression of stains generated on a printed material formed using a planographic printing plate to be obtained in a case where the planographic printing plate is prepared by exposing a positive type planographic printing plate precursor and developing the resulting precursor after a lapse of time is expressed as "the temporal stability after exposure of the positive type planographic printing plate precursor is high".

An object of an embodiment of the present invention is to provide a positive type planographic printing plate precursor from which a planographic printing plate with excellent chemical resistance and printing durability is obtained and which has high temporal stability after exposure.

Another object of the present invention is to provide a method of producing a planographic printing plate obtained by using the positive type planographic printing plate precursor.

For solving the above-described problems the present invention provides a printing plate precursor, which is a positive type planographic printing plate precursor, comprising:
(i) a support which has a hydrophilic surface and, on the support,
(ii) an image recording layer comprising:
   - a polymer compound 1 comprising at least one bond selected from a urea bond, a urethane bond, and a carbonate bond in a main chain and comprising a sulfonamide group in the main chain;
   - a polymer compound 2-2 comprising a constitutional unit of Formula EV-1 and a constitutional unit of Formula EV-2: 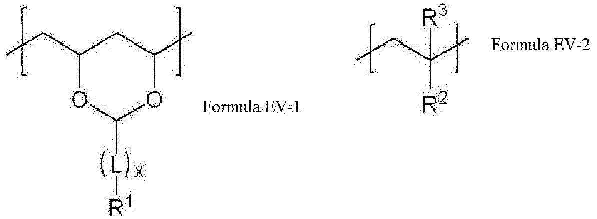 wherein L is a divalent linking group, X is 0 or 1, R¹ is an aromatic ring containing at least one hydroxyl group or heteroaromatic ring containing at least one hydroxy group, and R² and R³ each independently are H, halogen, an optionally substituted aromatic or heteroaromatic ring, or an optionally substituted linear, branched or cyclic alkyl or alkenyl group; and
   - an infrared absorbent.

Also, the invention provides a method of producing a planographic printing plate, comprising image-wise light exposing the above printing plate precursor; and developing the exposed printing plate precursor using an alkali aqueous solution having a pH of 8.5-13.5.

Preferred embodiments of the invention are as defined in the appended dependent claims and/or in the following detailed description.

According to the present invention, it is possible to provide a positive type planographic printing plate precursor from which a planographic printing plate with excellent chemical resistance and printing durability is obtained and which has high temporal stability after exposure. Further, it is possible to provide a method of producing a planographic printing plate obtained by using the positive type planographic printing plate precursor.

### DESCRIPTION OF THE PREFERRED EMBODIMENTS

Hereinafter, the contents of the present disclosure will be described in detail. The description of constituent elements below is made based on representative embodiments of the present disclosure in some cases, but the present disclosure is not limited to such embodiments. Further, in the present disclosure the following applies.

The numerical ranges shown using "to" indicate ranges including the numerical values described before and after "to" as the lower limit values and the upper limit values.

In a case where substitution or unsubstitution is not noted in regard to the notation of a group (atomic group), the group includes not only a group that does not have a substituent but also a group having a substituent. For example, the concept of an "alkyl group" includes not only an alkyl group that does not have a substituent (unsubstituted alkyl group) but also an alkyl group having a substituent (substituted alkyl group).

In addition, "% by mass" has the same definition as that for "% by weight" and "part(s) by mass" has the same definition as that for "part(s) by weight".

A combination of two or more preferred aspects is a more preferred aspect.

The "main chain" indicates the relatively longest bonding chain in a molecule of a polymer compound constituting a resin, and a "side chain" indicates a molecular chain branched from the main chain.

Further, the weight-average molecular weight (Mw) and the number average molecular weight (Mn) indicate a molecular weight obtained by performing detection using a gel permeation chromatography (GPC) analyzer, for which TSKgel GMHxL, TSKgel G4000HxL, and TSKgel G2000HxL (all trade names, manufactured by Tosoh Corporation) are used as columns, tetrahydrofuran (THF) as a solvent, and a differential refractometer and by performing conversion using polystyrene as a standard substance, unless otherwise specified.

A "group which may have a substituent" indicates both of a group which has a substituent and a group which does not have a substituent. For example, an alkyl group which may have a substituent includes both of an alkyl group which has a substituent and an alkyl group which does not have a substituent.

Hereinafter, the present disclosure will be described in detail.

### (Positive type planographic printing plate precursor)

A positive type planographic printing plate precursor of the present disclosure (hereinafter, also simply referred to as the "present printing plate precursor") includes a support which has a hydrophilic surface (hereinafter, also simply referred to as a "support"); and an image recording layer which contains a polymer compound 1 having at least one bond selected from a urea bond, a urethane bond, and a carbonate bond in the main chain and containing a sulfonamide group in the main chain, a polymer compound 2-2 having a constitutional unit of Formula EV-1 and a constitutional unit of Formula EV-2, and an infrared absorbent, on the support.

The present printing plate precursor may have the image recording layer on the support, and the support and the image recording layer are in contact with each other or another layer (for example, an undercoat layer) is provided between the support and the image recording layer.

As the result of intensive research conducted by the present inventors, it was found that a positive type planographic printing plate precursor from which a planographic printing plate with excellent chemical resistance and printing durability is obtained and which has high temporal stability after exposure is obtained by employing the above-described configuration.

The mechanism for obtaining the excellent effect by employing the above-described configuration is not clear, but can be assumed as follows.

It is considered that a sulfonamide group or phenolic hydroxyl group in a side chain which is contained in the polymer compound 2-2 easily interacts with the sulfonamide group contained in the main chain of the polymer compound 1 because the sulfonamide group or phenolic hydroxyl group has less steric hindrance.

Accordingly, it is speculated that the printing durability and the chemical resistance become excellent because the interaction between resins is strengthened and the strength of an image area of a printing plate to be obtained is improved, compared to a case where the polymer compound 1 is contained alone or a case where the polymer compound 2-2 is contained alone.

Further, it is considered that, in a case where the image recording layer contains two kinds of polymer compounds, which are the polymer compound 1 and the polymer compound 2-2, the interaction between low-molecular components such as an infrared absorbent and polymer compounds is dispersed in these two kinds of polymer compounds so that recovery of the interaction after exposure is effectively suppressed.

Therefore, it is speculated that the temporal stability of the positive type planographic printing plate precursor after exposure is increased (in other words, "the burnability is excellent").

### <Image recording layer>

The present printing plate precursor includes an image recording layer which contains a polymer compound 1 having at least one bond selected from the group consisting of a urea bond, a urethane bond, and a carbonate bond in a main chain and containing a sulfonamide group in the main chain, a polymer compound 2-2 having a constitutional unit of Formula EV-1 and a constitutional unit of Formula EV-2, and an infrared absorbent.

The image recording layer can be formed by, for example, dissolving each component contained in the image recording layer in a solvent and coating the support with the solvent.

Examples of the solvent to be used here include ethylene dichloride, cyclohexanone, methyl ethyl ketone, methanol, ethanol, propanol, ethylene glycol monomethyl ether, 1-methoxy-2-propanol, 2-methoxy ethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, and toluene, but the present invention is not limited to these examples. These solvents may be used alone or in the form of a mixture.

Hereinafter, each component contained in the image recording layer will be described in detail.

### [Polymer compound 1]

The polymer compound 1 is a polymer compound which has at least one bond selected from a urea bond, a urethane bond, and a carbonate bond in the main chain and contains a sulfonamide group in the main chain,

### - Urea bond, urethane bond, and carbonate bond -

The polymer compound 1 has at least one of a urea bond, a urethane bond, and a carbonate bond in the main chain.

Further, it is preferable that the main chain skeleton of the polymer compound 1 is at least one of a urea bond, a urethane bond, and a carbonate bond.

As the main chain skeleton of the polymer compound 1, a urethane bond is preferable from the viewpoint of achieving the image formability, the printing durability, and the manufacturing suitability, and a urea bond is preferable from the viewpoint of achieving the chemical resistance, the printing durability, and the developability.

The urea bond, the urethane bond, and the carbonate bond contained in the main chain of the polymer compound 1 are each a bond of the following chemical formulae:

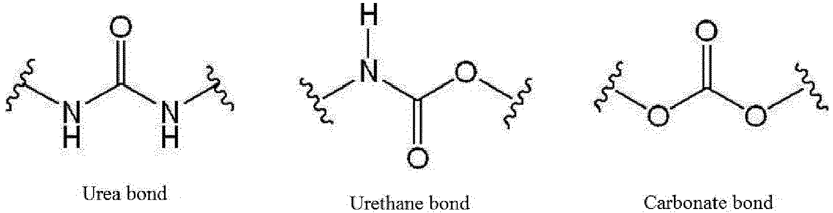

### - Acid group in main chain or side chain -

The polymer compound 1 contains a sulfonamide group in the main chain.

It is preferable that the polymer compound 1 contains another acid group in a side chain. As the acid group in a side chain, a phenolic hydroxyl group, a sulfonamide group, or a carboxy group is preferable.

Further, the polymer compound corresponding to the polymer compound 2-2, that is, the polymer compound having a constitutional unit of Formula EV-1 and a constitutional unit of Formula EV-2 are set to those that do not correspond to the polymer compound 1.

### - Polycyclic structure -

From the viewpoints of the printing durability and the chemical resistance, it is preferable that the polymer compound 1 further has a polycyclic structure in the main chain.

The polycyclic structure indicates a fused cyclic hydrocarbon structure, a fused polycyclic aromatic structure, or a structure formed by a plurality of aromatic hydrocarbons being bonded through a single bond. As the polycyclic structure, a naphthalene derivative structure, an anthracene derivative structure, a biphenyl structure, or a terphenyl structure is preferable. Among examples of the naphthalene derivative structure and the anthracene derivative structure, a naphthalene structure, a xanthone structure, an anthrone structure, a xanthene structure, a dihydroanthracene structure, and an anthracene structure are preferable, and from the viewpoints of the chemical resistance, the printing durability, and the developability, a xanthone structure, an anthrone structure, a biphenyl structure, and a naphthalene structure are more preferable, and a xanthone structure and an anthrone structure are still more preferable.

### - Constitutional unit of Formula A-1 -

It is preferable that the polymer compound 1 has a constitutional unit of Formula A-1 as the constitutional unit containing a sulfonamide group.

Two sulfonamide groups contained in Formula A-1 are each a sulfonamide group contained in the polymer compound 1 in the main chain.

In a case where the polymer compound 1 has a constitutional unit of Formula A-1, since the acid value of the polymer compound 1 is increased in the structure thereof, a positive type planographic printing plate precursor having excellent developability is obtained.

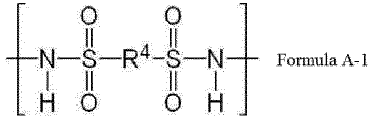

In Formula A-1, R⁴ is a divalent linking group, preferably a divalent linking group having the above-described polycyclic structure or a divalent linking group having a phenylene group, and more preferably a divalent linking group having the above-described polycyclic structure from the viewpoint of the printing durability.

The content of the constitutional unit of Formula A-1 in the polymer compound 1 is preferably 10-90mass%, more preferably 30-80 mass%, and still more preferably 50-75 mass% with respect to the total mass of the polymer compound 1.

### - Divalent linking group containing phenylene group -

As the divalent linking group containing a phenylene group, phenylene or a group of Formula Ph-1 is preferable.

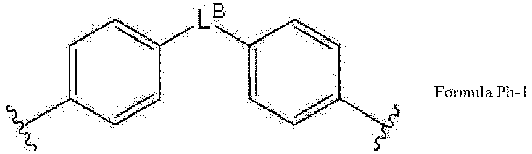

In Formula Ph-1, L^{B} is an ether bond (-O-) or a sulfonyl group (-S(=O)₂-), and wavy line parts each represent a bonding site with respect to a sulfur atom of the sulfonamide group in Formula A-1.

In a case where R⁴ is phenylene, it is preferable that two sulfonamide groups in Formula A-1 are bonded to the phenylene group so as to be the meta-position.

Further, the phenylene group may be substituted. Examples of the substituent include alkyl, hydroxy and halogen. Among these, alkyl is preferable. As the alkyl group, C₁₋₈-alkyl is preferable, C₁₋₄-alkyl is more preferable, and methyl is still more preferable.

### - Constitutional unit of Formulae B1-1 to B1-6 -

It is preferable that the constitutional unit of Formula A-1 contains a constitutional unit of any of Formulae B1-1 to B1-6 and more preferable that the constitutional unit of Formula A-1 contains a constitutional unit of Formula B1-1 or B1-2.

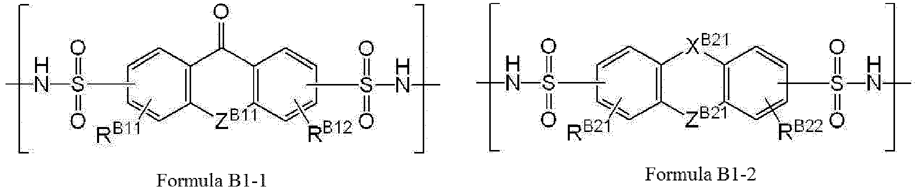

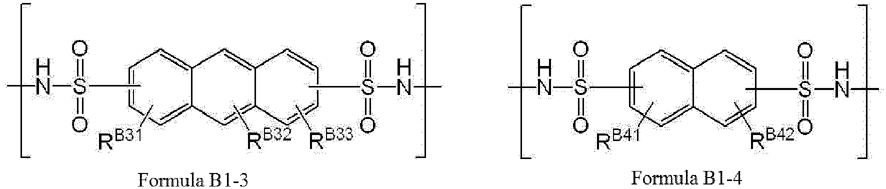

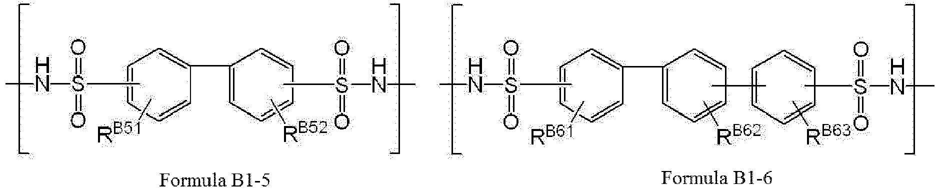

In Formulae B1-1 to B1-6, each of R^{B11}, R^{B12}, R^{B21}, R^{B22}, R^{B31} to R^{B33}, R^{B41}, R^{B42}, R^{B51}, R^{B52}, and R^{B61}-R^{B63} each independently are H, a sulfonamide group, hydroxy, carboxy, alkyl or halogen, Z^{B11} is -C(R)₂-, -C(=O)-, -O-, -NR-, -S-, or a single bond, Z^{B21} is -C(R)₂-, -O-, -NR-, -S-, or a single bond, R each independently is H or alkyl, X^{B21} is -C(R')₂-, -O-, -NR'-, -S-, or a single bond, and of R' each independently is H or alkyl.

Preferably, R^{B11}, R^{B12}, R^{B21}, R^{B22}, R^{B31} to R^{B33}, R^{B41}, R^{B42}, R^{B51}, R^{B52}, and R^{B61}-R^{B63} each independently are H, alkyl or halogen, and more preferably H. From the viewpoint of improving the developability, an acid group such as a sulfonamide group, a hydroxyl group, or a carboxy group is preferable.

Preferably, Z^{B11} and Z^{B21} each independently represents -C(R)₂-, -O-, -NR-, -S-, or a single bond, preferably -C(R)₂- or -O-, and more preferably -O-.

X^{B21} preferably is -C(R')₂-. Also, R and R' each are preferably H.

The content of the structure of any of Formulae B1-1 to B1-6 in the polymer compound 1 is preferably 10-90 mass%, more preferably 30-80 mass%, and still more preferably 50-75 mass% with respect to the total mass of the polymer compound 1.

### - Constitutional unit of Formula A-2 -

It is preferable that the polymer compound 1 has a constitutional unit of formula A-2 as the constitutional unit containing a sulfonamide group.

Both of two sulfonamide groups contained in Formula A-2 are sulfonamide groups contained in the polymer compound 1 in the main chain thereof: 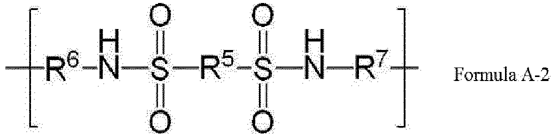 whereinR⁵-R⁷ independently are a divalent linking group.

In Formula A-2, R⁵ has the same definition as that for R⁴ in Formula A-1 and the preferable aspects thereof are the same as described above.

In Formula A-2, each of R⁶ and R⁷ independently represents a divalent linking group, preferably an alkylene group, an arylene group, or a divalent saturated alicyclic hydrocarbon group, a divalent unsaturated alicyclic hydrocarbon group, or a divalent group formed by a plurality of these groups being linked to one another, and more preferably an alkylene group or an arylene group.

As the alkylene group, C₁₋₂₀-alkylene is preferable, C₂₋₁₅-alkylene is more preferable, and C₂₋₈-alkylene is still more preferable. Further, the alkylene group may contain oxygen atoms in a carbon chain. Examples of the substituent which may be included in the alkylene group include alkyl, aryl and halogen.

As the arylene group, C₆₋₂₀-arylene is preferable, phenylene or naphthylene is more preferable, and phenylene is still more preferable. The arylene group may contain heteroatoms in a ring structure, and examples of the heteroatom include an oxygen atom, a nitrogen atom, and a sulfur atom.

As the divalent saturated alicyclic hydrocarbon group, a C₄₋₁₀-hydrocarbon group is preferable, a C₄₋₈-hydrocarbon group is more preferable, and a C₆₋₈-hydrocarbon group is still more preferable. Further, examples of the substituent which may be contained in the divalent saturated alicyclic hydrocarbon group include an alkyl group, an aryl group, and a halogen atom.

As the divalent unsaturated alicyclic hydrocarbon group, cyclopentenyl, cyclopentadienyl, cyclohexenyl, cyclohexadienyl, and cycloheptenyl are exemplified.

As the divalent group formed by a plurality of these groups being linked to one another, a group in which a plurality of alkylene groups and arylene groups or a plurality of alkylene groups and divalent saturated alicyclic hydrocarbon groups are bonded is preferable and a group in which an alkylene group, an arylene group, and an alkylene group or an alkylene group, a divalent saturated alicyclic hydrocarbon group, and an alkylene group are bonded in this order is preferable.

### - Constitutional units of Formulae B2-1 to B2-6 -

It is preferable that the constitutional unit of Formula A-2 contains a constitutional unit of any of Formulae B2-1 to B2-6 and more preferable that the constitutional unit of Formula A-2 contains a constitutional unit of Formula B2-1 or B2-2: 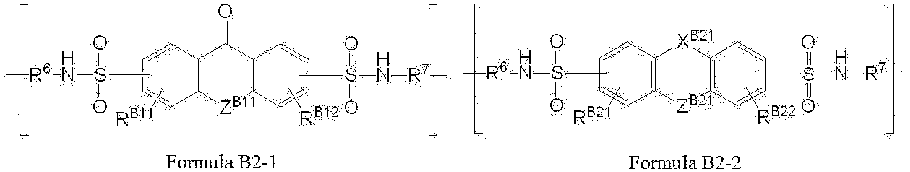 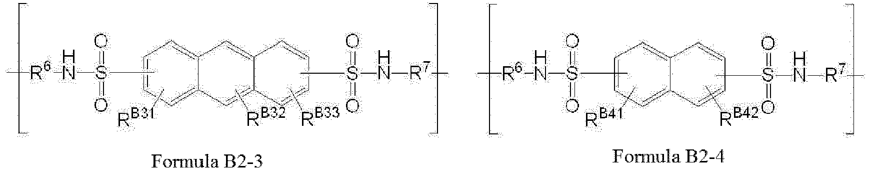 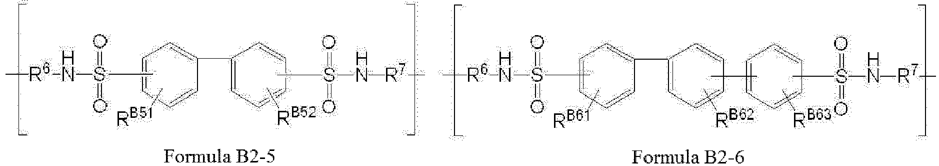 wherein R⁶ and R⁷ each have the same definition as R⁶ and R⁷ in Formula A-2 and the preferable aspects thereof are the same as described above, and R^{B11}, R^{B12}, R^{B21}, R^{B22}, R^{B31} to R^{B33}, R^{B41}, R^{B42}, R^{B51}, R^{B52}, R^{B61} to R^{B63}, Z^{B11}, Z^{B21}, and X^{B21} each have the same definition as in Formulae B1-1 to B1-6 and the preferable aspects thereof are the same as described above.

From the viewpoint of the developability of the planographic printing plate to be obtained, the content of the constitutional unit of Formula A-2 in the polymer compound 1 is preferably 10-90 mass%, more preferably 20-80 mass%, and still more preferably 30-70 mass% with respect to the total mass of the polymer compound 1.

It is preferable that the constitutional unit of Formula A-2 is a constitutional unit derived from a specific diamine compound containing a sulfonamide group described below in the main chain or a specific diol compound containing a sulfonamide group in the main chain.

### - Alkyleneoxy group -

It is preferable that the polymer compound 1 further contains an alkyleneoxy group in the main chain.

According to the above-described embodiment, it is possible to obtain a planographic printing plate precursor from which a planographic printing plate with excellent image formability and excellent printing durability is obtained.

As the alkyleneoxy group, C₂₋₁₀-alkyleneoxy is preferable, C₂₋₈-alkyleneoxy is more preferable, C₂₋₄-alkyleneoxy is still more preferable, and ethyleneoxy or propyleneoxy is particularly preferable.

Further, the alkyleneoxy group may be a polyalkyleneoxy group.

The polyalkyleneoxy group preferably has 2-50, more preferably 2-40, and still more preferably 2-30, repeating units.

The preferable number of carbon atoms in the repeating units constituting the polyalkyleneoxy group is the same as the preferable number of carbon atoms of the alkyleneoxy group.

### - Example of polymer compound 1 -

It is preferable that the polymer compound 1 is a polymer compound having a combination of constitutional units of any of Formulae D-1 to D-3.

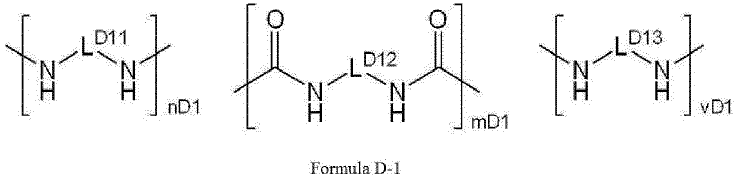

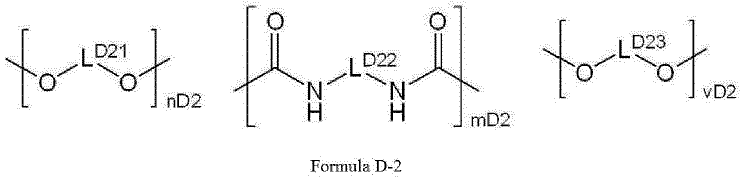

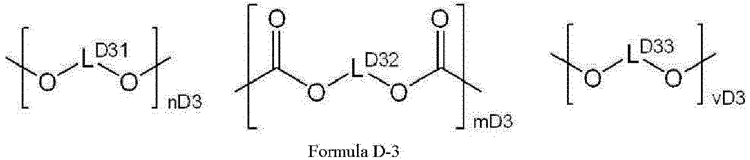

In Formulae D-1 to D-3, each of L^{D11}, L^{D21}, and L^{D31} independently is a constitutional unit of Formula A-2 and the preferable aspects thereof are the same as described above.

In Formulae D-1 to D-3, each of L^{D12}, L^{D22}, and L^{D32} independently are alkylene, arylene, carbonyl, sulfonyl, an amide bond, a urethane bond, a single bond, or a linking group formed by two or more of these bonds being bonded to each other, preferably C₁₋₂₀-alkylene, C₆₋₂₀-arylene, carbonyl, sulfonyl, an amide bond, a urethane bond, a single bond, or a linking group formed by two or more of these bonds being bonded to each other, more preferably C₁₋₁₅-alkylene, phenylene, naphthylene, carbonyl, sulfonyl, amide bond, a urethane bond, a single bond, or a linking group formed by two or more of these bonds being bonded to each other, and still more preferably C₁₋₁₅-alkylene, phenylene, naphthylene, or a linking group formed by two or more of these bonds being bonded to each other.

In Formulae D-1 to D-3, each of L^{D13}, L^{D23}, and L^{D33} independently is alkylene, alkyleneoxy, arylene, carbonyl, sulfonyl, an amide bond, a urethane bond, a single bond, or a linking group formed by two or more of these bonds being bonded to each other, preferably C₁₋₂₀-alkylene, an C₂₋₁₀-alkyleneoxy, C₆₋₂₀-arylene , carbonyl, sulfonyl, an amide bond, a urethane bond, a single bond, or a linking group formed by two or more of these bonds being bonded to each other, more preferably C₁₋₁₅-alkylene, C₂₋₈-alkyleneoxy, phenylene, naphthylene, carbonyl, sulfonyl, an amide bond, a urethane bond, a single bond, or a linking group formed by two or more of these bonds being bonded to each other, and still more preferably C₁₋₁₅-alkylene, an C₂₋₄-alkyleneoxy, phenylene, naphthylene, or a linking group formed by two or more of these bonds being bonded to each other.

Further, the alkyleneoxy group may form a polyalkyleneoxy group. The polyalkyleneoxy group preferably has 2-50, more preferably 2-40, and still more preferably 2-30, repeating units. The preferable number of carbon atoms in the repeating units constituting the polyalkyleneoxy group is the same as the preferable number of carbon atoms of the alkyleneoxy group.

In a case where L^{D13}, L^{D23} or L^{D33} represents an alkyleneoxy group, it is possible to obtain a positive type planographic printing plate precursor from which a planographic printing plate with excellent image formability and excellent printing durability is obtained.

In Formula D-1, nD1, mD1, and vD1 represent a content ratio (mass ratio) in a case where the total mass of molecules of the polymer compound 1 is set to 100, and nD1:mD1:vD1 is preferably in a range of 90:10:0 to 30:60:10 and more preferably in a range of 80:20:0 to 60:30:10. Further, the total value of nD1 and mD1 is preferably 90 or greater and more preferably 95 or greater. The total value of nD1, mD1, and vD1 is preferably 90 or greater, more preferably 95 or greater, and still more preferably 98 or greater.

In Formula D-2, nD2, mD2, and vD2 represent a content ratio (mass ratio) in a case where the total mass of molecules of the polymer compound 1 is set to 100, and nD2:mD2:vD2 is preferably in a range of 90:10:0 to 30:60:10 and more preferably in a range of 80:20:0 to 60:30:10. Further, the total value of nD2 and mD2 is preferably 90 or greater and more preferably 95 or greater. The total value of nD2, mD2, and vD2 is preferably 90 or greater, more preferably 95 or greater, and still more preferably 98 or greater.

In Formula D-3, nD3, mD3, and vD3 represent a content ratio (mass ratio) in a case where the total mass of molecules of the polymer compound 1 is set to 100, and nD3:mD3:vD3 is preferably in a range of 90:10:0 to 30:60:10 and more preferably in a range of 80:20:0 to 60:30:10. Further, the total value of nD3 and mD3 is preferably 90 or greater and more preferably 95 or greater. The total value of nD3, mD3, and vD3 is preferably 90 or greater, more preferably 95 or greater, and still more preferably 98 or greater.

The compound having a combination of a plurality of constitutional units of Formula D-1 can be produced by a sequential polymerization reaction of a diamine compound formed by an amino group being bonded to both terminals of the structure L^{D11}, a diisocyanate compound formed by an isocyanate group being bonded to both terminals of the structure L^{D12}, and optionally a diamine compound formed by an amino group being bonded to a terminal of the structure L^{D13}.

The terminal of the compound having a combination of a plurality of constitutional units of Formula D-1 is not particularly limited, is typically an amino group or an isocyanate group, and may be blocked by a known terminal blocking agent such as a monoamine, a monoalcohol, or a monoisocyanate.

The compound having a combination of a plurality of constitutional units of Formula D-2 can be produced by a sequential polymerization reaction of a diol compound formed by a hydroxy group being bonded to both terminals of the structure L^{D21}, a diisocyanate compound formed by an isocyanate group being bonded to both terminals of the structure L^{D22}, and optionally a diol compound formed by a hydroxy group being bonded to a terminal of the structure L^{D23}.

The terminal of the compound having a combination of a plurality of constitutional units of Formula D-2 is not particularly limited, is typically a hydroxy group or an isocyanate group, and may be blocked by a known terminal blocking agent such as a monoamine, a monoalcohol, or a monoisocyanate.

The compound having a combination of a plurality of constitutional units of Formula D-3 can be produced by a sequential polymerization which is carried out using a compound containing a carbonate group such as alkyl carbonate and which occurs between a diol compound formed by a hydroxy group being bonded to both terminals of the structure L^{D41}, a diol compound formed by a hydroxy group being bonded to both terminals of the structure L^{D42}, and optionally a diol compound formed by a hydroxy group being bonded to a terminal of the structure L^{D43}.

The terminal of the compound having a combination of a plurality of constitutional units of Formula D-3 is not particularly limited, is typically a hydroxy group, and may be blocked by a known terminal blocking agent such as a monoalcohol or a monoamine.

The weight-average molecular weight of the polymer compound 1 according to the present disclosure is preferably 10,000-500,000, more preferably 10,000-200,000, and still more preferably 20,000-100,000.

Hereinafter, the polymer compound 1 will be described based on specific examples.

### - Polyurea containing sulfonamide group in main chain -

As the polymer compound 1, polyurea containing a sulfonamide group in the main chain is preferable.

The polyurea containing a sulfonamide group in the main chain is a polymer generated by a sequential polymerization reaction of a specific diamine compound containing a sulfonamide group in the main chain and a compound (diisocyanate compound) containing two or more isocyanate groups. Further, the polyurea is not particularly limited as long as the polyurea contains a sulfonamide group in the main chain.

Preferred examples of the specific diamine compound containing a sulfonamide group in the main chain include compounds SA-1 to SA-26 described below.

Further, the main chain of the diamine compound indicates a carbon chain serving as the main chain of a polymer compound in a case where a polymer compound such as polyurea is formed.

Specific preferred examples of the polyurea which can be used in the present disclosure are described below. Specific examples PU-1 to PU-20 indicate polymer compounds 1 formed by reacting a diamine compound containing a sulfonamide group described below in the main chain, a compound having two or more isocyanate groups, and optionally other diamine compounds at ratios (molar ratios) listed in the following table.

Further, the table shows molar ratios used for synthesis of polyureas and weight-average molecular weights (Mw) of obtained polyureas containing a sulfonamide group in the main chain, but the polyurea containing a sulfonamide group in the main chain which is used in the present disclosure is not limited to these.

In addition, the weight-average molecular weight of a polymer is a value measured according to the GPC method.

**[Table 1]**

| Polymer compound 1 | Diamine compound-1 (molar ratio thereof contained) | Diamine compound-2 (molar ratio thereof contained | Diisocyanate compound-1 (molar ratio thereof contained) | Diisocyanate compound-2 (molar ratio thereof contained) | Weight -average molecular weight (ten thousand) |
|---|---|---|---|---|---|
| PU-1 | SA-1 | - | HDI | - | 4.8 |
| | 50 | - | 50 | - | |
| PU-2 | SA-1 | - | MDI | - | 5.1 |
| | 50 | - | 50 | - | |
| PU-3 | SA-2 | - | HDI | - | 4.6 |
| | 50 | - | 50 | - | |
| PU-4 | SA-5 | - | H6-XDI | - | 4.9 |
| | 50 | - | 50 | - | |
| PU-5 | SA-7 | - | H6-XDI | - | 5.3 |
| | 50 | - | 50 | - | |
| PU-6 | SA-8 | - | H6-XDI | - | 6.5 |
| | 50 | - | 50 | - | |
| PU-7 | SA-11 | - | XDI | - | 4.2 |
| | 50 | - | 50 | - | |
| PU-8 | SA-11 | - | XDI | NBDI | 3.9 |
| | 50 | - | 25 | 25 | |
| PU-9 | SA-12 | - | NBDI | - | 5.5 |
| | 50 | - | 50 | - | |
| PU-10 | SA-13 | - | NBDI | - | 6.9 |
| | 50 | - | 50 | - | |
| PU-11 | SA-14 | - | H6-XDI | - | 7.1 |
| | 50 | - | 50 | - | |
| PU-12 | SA-15 | - | TDI | - | 10.5 |
| | 50 | - | 50 | - | |
| PU-13 | SA-22 | - | TDI | - | 5.3 |
| | 50 | - | 50 | - | |
| PU-14 | SA-23 | - | TDI | - | 6.9 |
| | 50 | - | 50 | - | |
| PU-15 | SA-23 | - | TDI | - | 5.5 |
| | 50 | - | 50 | - | |
| PU-16 | SA-23 | 6FAP | H6-XDI | - | 3.9 |
| | 40 | 10 | 50 | - | |
| PU-17 | SA-23 | DEGDAP | TDI | - | 9.2 |
| | 40 | 10 | 50 | - | |
| PU-18 | SA-24 | - | H6-XDI | - | 5.4 |
| | 50 | - | 50 | - | |
| PU-19 | SA-25 | - | H6-XDI | - | 6.2 |
| | 50 | - | 50 | - | |
| PU-20 | SA-26 | - | TDI | - | 8.5 |
| | 50 | - | 50 | - | |

The details of the compounds shown by using abbreviations in the table are as follows.

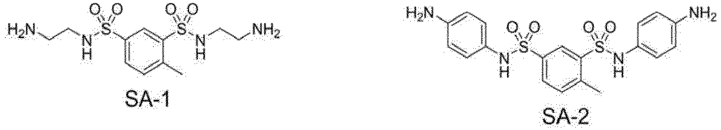

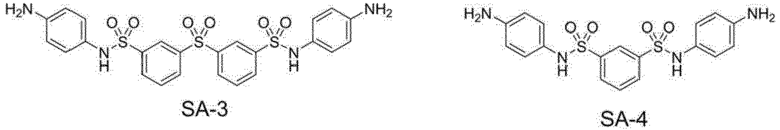

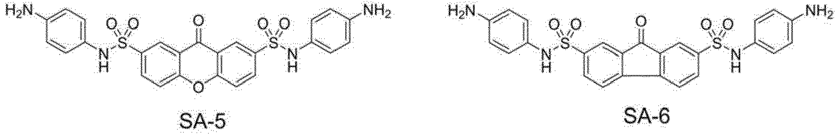

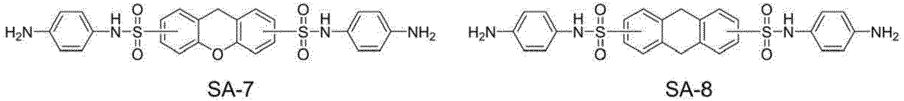

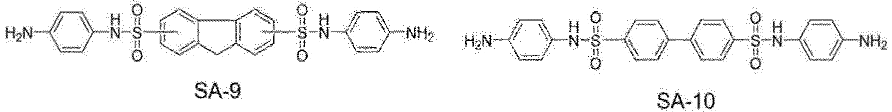

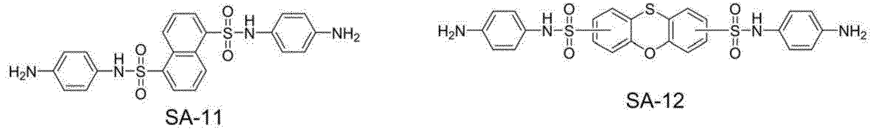

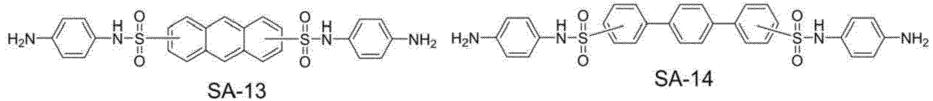

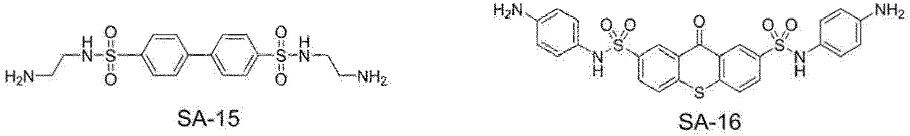

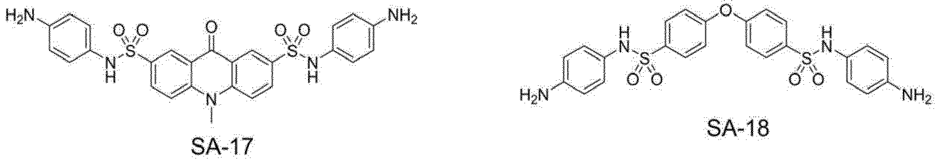

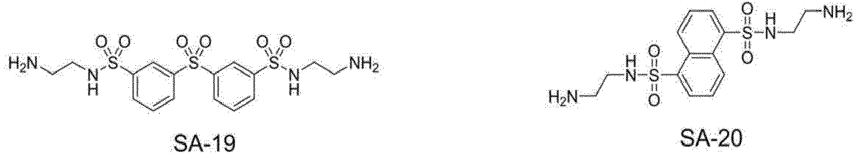

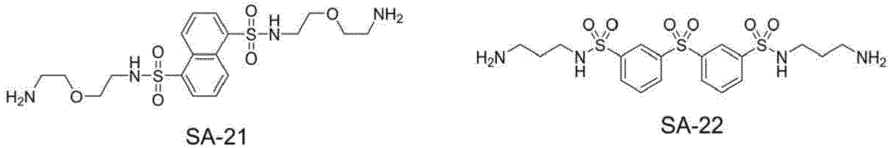

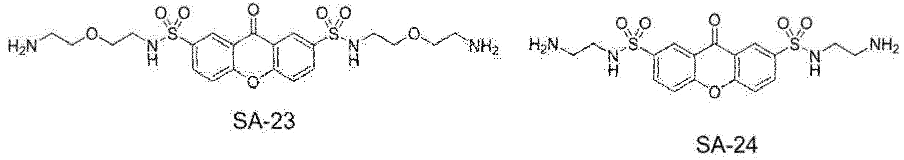

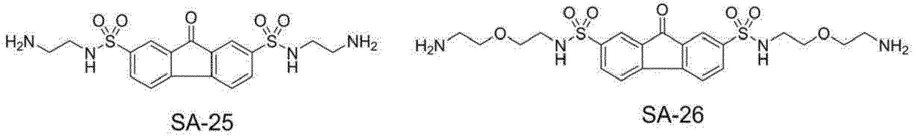

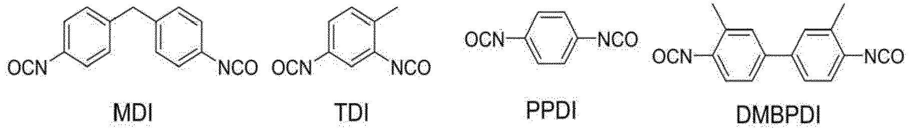

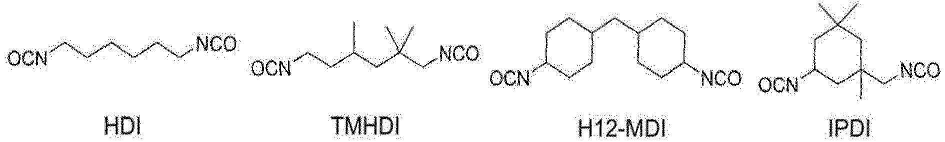

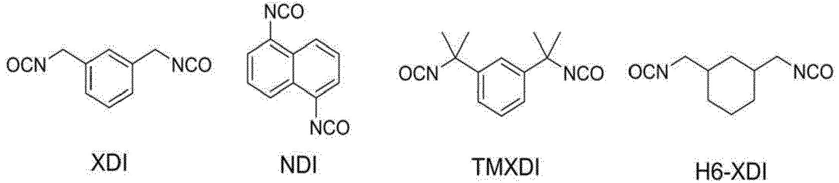

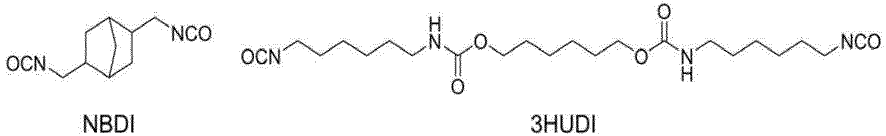

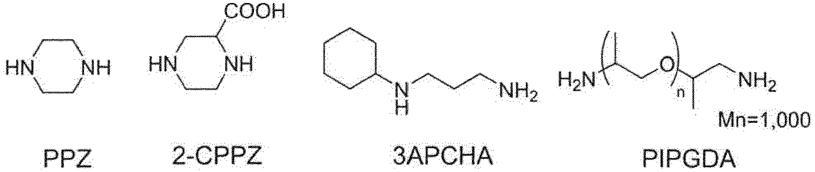

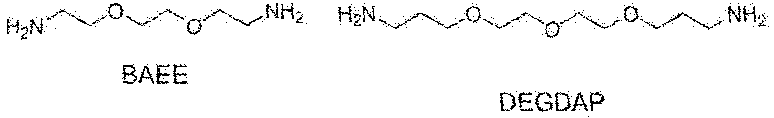

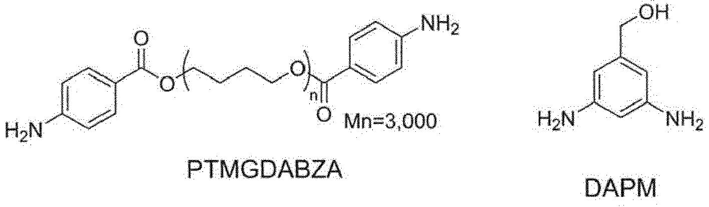

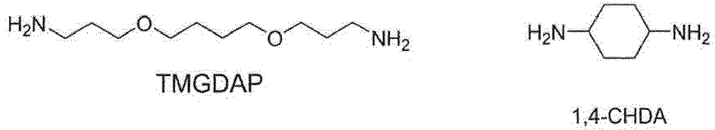

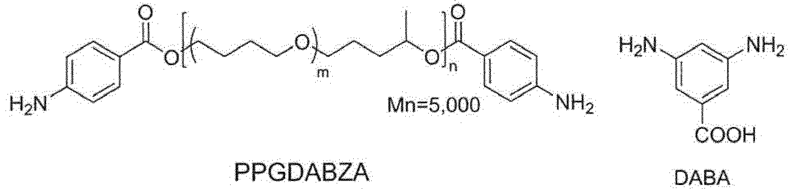

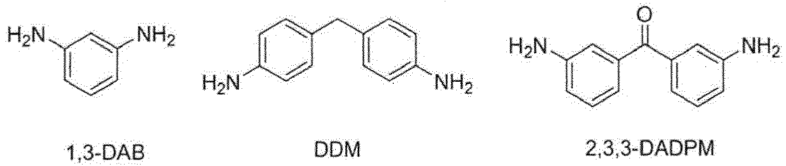

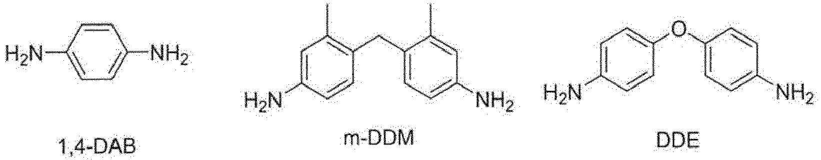

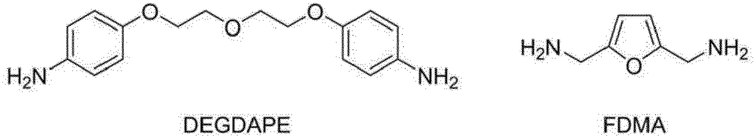

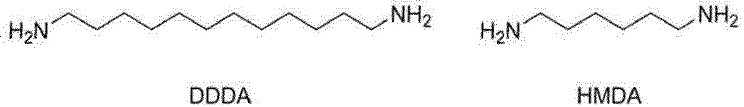

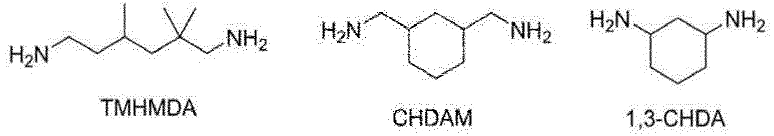

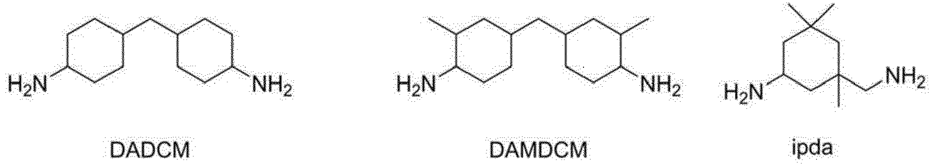

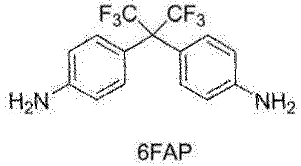

### - Polyurethane containing sulfonamide group in main chain -

As the polymer compound 1, polyurethane containing a sulfonamide group in the main chain is preferable.

The polyurethane which contains a sulfonamide group in the main chain is a polymer generated by a sequential polymerization reaction of a specific diol compound containing a sulfonamide group in the main chain and a compound having two or more isocyanate groups. Further, the polyurethane is not particularly limited as long as the polyurethane contains a sulfonamide group in the main chain.

Preferred examples of the specific diol compound containing a sulfonamide group in the main chain include compounds SB-1 to SB-26 described below.

In addition, the main chain of the diol compound indicates a carbon chain serving as the main chain of a polymer compound in a case where a polymer compound such as polyurethane is formed.

Specific preferred examples of the polyurethane which can be used in the present disclosure are shown in the following table. Specific examples PT-1 to PT-20 indicate polymer compounds 1 formed by reacting a diol compound containing a sulfonamide group in the main chain and a compound having two or more isocyanate groups at ratios (molar ratios) listed in the following table.

In addition, the table shows molar ratios used for synthesis of polyurethanes and weight-average molecular weights (Mw) of obtained specific polyurethanes containing a sulfonamide group in the main chain, but the polyurethane containing a sulfonamide group in the main chain which is used in the present disclosure is not limited to these.

Moreover, the weight-average molecular weight of a polymer is a value measured according to the GPC method.

**[Table 2]**

| Polymer compound 1 | Diol compound-1 (molar ratio thereof contained) | Diol compound-2 (molar ratio thereof contained | Diisocyanate compound-1 (molar ratio thereof contained) | Diisocyanate compound-2 (molar ratio thereof contained) | Weight -average molecular weight (ten thousand) |
|---|---|---|---|---|---|
| PT-1 | SB-1 | - | MDI | - | 4.3 |
| | 50 | - | 50 | - | |
| PT-2 | SB-2 | - | MDI | TDI | 5.5 |
| | 50 | - | 40 | 10 | |
| PT-3 | SB-3 | - | H6-XDI | - | 6.2 |
| | 50 | - | 50 | - | |
| PT-4 | SB-4 | - | H6-XDI | - | 5.1 |
| | 50 | - | 50 | - | |
| PT-5 | SB-5 | - | H6-XDI | - | 5.8 |
| | 50 | - | 50 | - | |
| PT-6 | SB-10 | - | H6-XDI | - | 5.4 |
| | 50 | - | 50 | - | |
| PT-7 | SB-12 | - | H6-XDI | - | 4.4 |
| | 50 | - | 50 | - | |
| PT-8 | SB-17 | - | H6-XDI | - | 4.8 |
| | 50 | - | 50 | - | |
| PT-9 | SB-18 | - | H6-XDI | - | 4.3 |
| | 50 | - | 50 | - | |
| PT-10 | SB-19 | - | MDI | TDI | 4.3 |
| | 50 | - | 40 | 10 | |
| PT-11 | SB-20 | - | MDI | TDI | 6.9 |
| | 50 | - | 40 | 10 | |
| PT-12 | SB-20 | - | TDI | - | 4.5 |
| | 50 | - | 50 | - | |
| PT-13 | SB-23 | - | TDI | - | 4.7 |
| | 50 | - | 50 | - | |
| PT-14 | SB-23 | - | TDI | MDI | 5.5 |
| | 50 | - | 40 | 10 | |
| PT-15 | SB-23 | DO-9 | TDI | - | 5.1 |
| | 45 | 5 | 50 | - | |
| PT-16 | SB-23 | DO-10 | TDI | - | 4.6 |
| | 45 | 5 | 50 | - | |
| PT-17 | SB-26 | - | XDI | - | 5.5 |
| | 50 | - | 50 | - | |
| PT-18 | SB-26 | - | XDI | - | 11.3 |
| | 50 | - | 50 | - | |
| PT-19 | SB-26 | - | H6-XDI | - | 5.5 |
| | 50 | - | 50 | - | |
| PT-20 | SB-26 | DO-9 | H6-XDI | - | 6.3 |
| | 50 | 5 | 50 | - | |

Among the compounds shown by using abbreviations in the table, the details of compounds other than the above-described compounds are as follows.

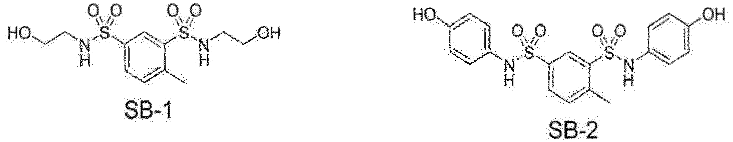

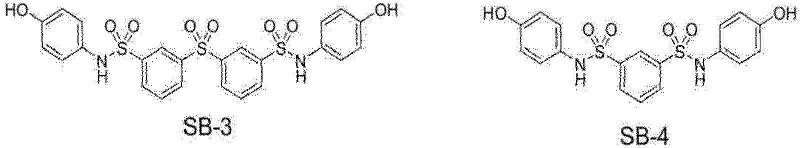

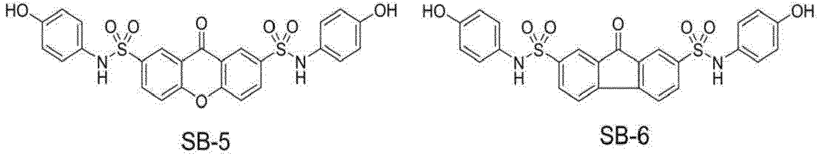

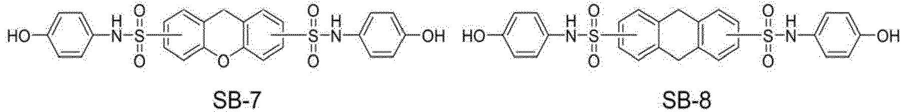

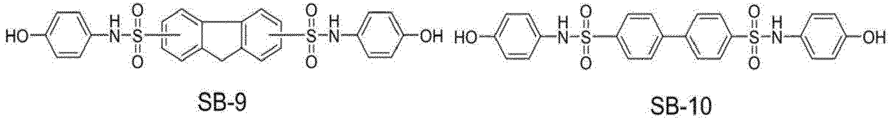

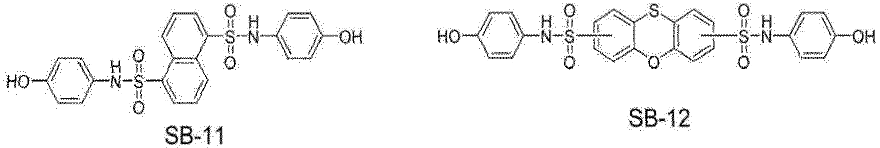

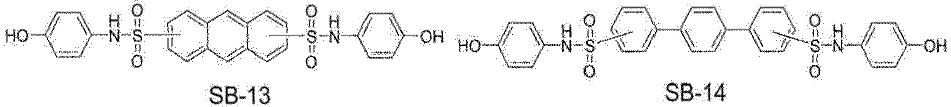

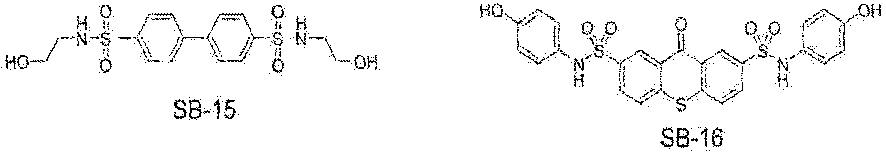

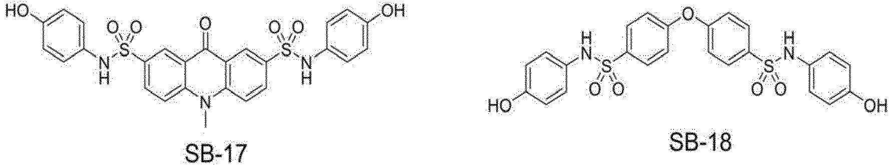

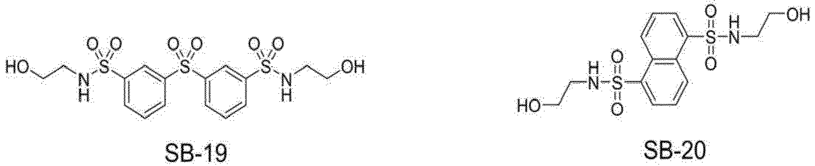

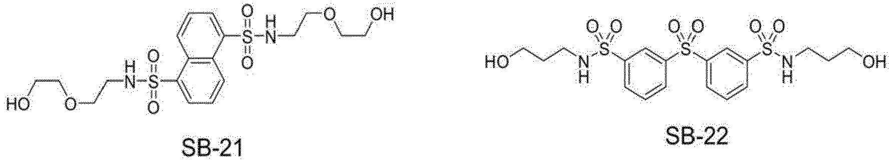

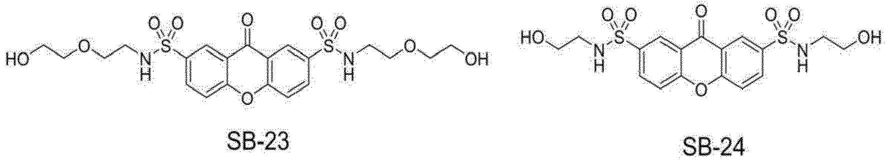

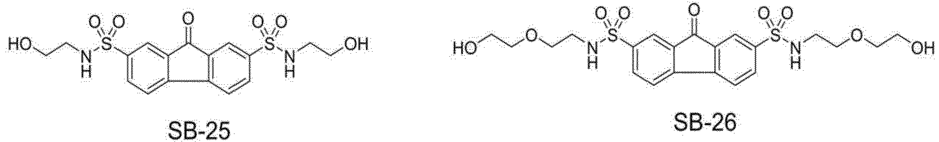

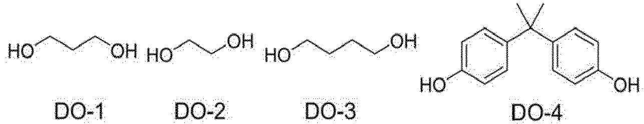

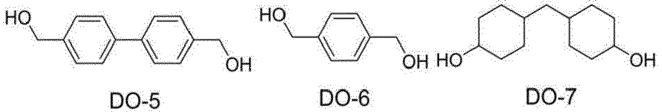

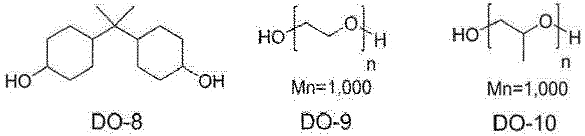

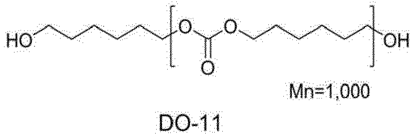

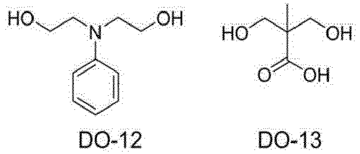

### - Polycarbonate containing sulfonamide group in main chain -

As the polymer compound 1, polycarbonate containing a sulfonamide group in the main chain is preferable.

The polycarbonate which contains a sulfonamide group in the main chain is a polymer which is obtained by using a compound (for example, diethyl carbonate) containing a carbonate group such as alkyl carbonate and is generated by a sequential polymerization reaction of a diol compound and a diol compound containing a sulfonamide group in the main chain. Further, the polycarbonate is not particularly limited as long as the polycarbonate contains a sulfonamide group in the main chain.

Preferred examples of the diol compound containing a sulfonamide group in the main chain include compounds SB-1 to SB-26 described above.

**[Table 3]**

| Polymer compound 1 | Diol compound-1 (molar ratio thereof contained) | Diol compound-2 (molar ratio thereof contained) | Diol compound-3 (molar ratio thereof contained) | Weight -average molecular weight (ten thousand) |
|---|---|---|---|---|
| PC-1 | SB-1 | DO-3 | - | 6.1 |
| | 70 | 30 | - | |
| PC-2 | SB-1 | DO-4 | - | 5.4 |
| | 70 | 30 | - | |
| PC-3 | SB-2 | DO-3 | - | 3.9 |
| | 70 | 30 | - | |
| PC-4 | SB-5 | DO-3 | - | 7.5 |
| | 70 | 30 | - | |
| PC-5 | SB-20 | DO-1 | - | 5.9 |
| | 70 | 30 | - | |
| PC-6 | SB-23 | DO-1 | - | 5.3 |
| | 70 | 30 | - | |
| PC-7 | SB-23 | DO-1 | - | 11.5 |
| | 70 | 30 | - | |
| PC-8 | SB-23 | DO-4 | - | 6.7 |
| | 65 | 35 | - | |
| PC-9 | SB-23 | DO-6 | - | 8.2 |
| | 70 | 30 | - | |
| PC-10 | SB-23 | DO-1 | DO-9 | 8.5 |
| | 70 | 25 | 5 | |
| PC-11 | SB-26 | DO-6 | - | 4.5 |
| | 70 | 30 | - | |
| PC-12 | SB-26 | DO-6 | DO-13 | 6.5 |
| | 70 | 25 | 5 | |
| PC-13 | SB-10 | DO-2 | - | 9.5 |
| | 70 | 30 | - | |
| PC-14 | SB-13 | DO-2 | - | 10.2 |
| | 70 | 30 | - | |

### - Content -

Further, the content of the polymer compound 1 in the image recording layer of the present disclosure is preferably 10-90 mass%, more preferably 20-80 mass%, and still more preferably 30-80 mass% with respect to the total mass of the image recording layer.

### [Polymer compound 2-2]

### - Constitutional unit of Formula EV-1 and constitutional unit of Formula EV-2 -

The polymer compound 2-2 used in the present disclosure contains a constitutional unit of Formula EV-1 and a constitutional unit of Formula EV-2: 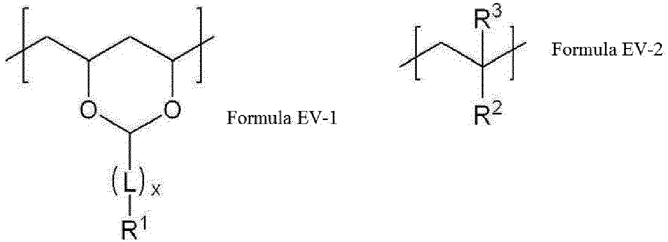 wherein L is a divalent linking group, X is 0 or 1, R¹ is an aromatic or heteroaromatic ring containing at least one hydroxy group, and R² and R³ each independently are H, halogen, an optionally substituted aromatic or heteroaromatic ring, or an optionally substituted linear, branched or cyclic alkyl or alkenyl group

R¹ is an aromatic or heteroaromatic ring which contains at least one hydroxy group, and the hydroxy group may be contained in any of the ortho, meta, or para position with respect to the bonding site with L.

Preferred examples of the aromatic ring include phenyl, benzyl, tolyl, o-, m-, or p-xylyl, naphthyl, anthracenyl and phenanthrenyl.

Preferred examples of the heteroaromatic ring include furyl, pyridyl, pyrimidyl, pyrazoyl and thiophenyl.

These aromatic rings or heteroaromatic rings may have a substituent other than a hydroxyl group, and examples of the substituent include alkyl such as methyl or ethyl, alkoxy such as methoxy or ethoxy, an azo group, aryloxy, thioalkyl, thioaryl, -SH, azoalkyl or azophenyl, thioalkyl, amino, ethenyl, alkenyl, alkynyl, cycloalkyl, aryl, heteroaryl and a heteroalicyclic group.

R¹ is preferably hydroxyphenyl or hydroxynaphthyl which contains a hydroxy group and more preferably hydroxyphenyl.

Examples of the hydroxyphenyl group include 2-hydroxyphenyl, 3-hydroxyphenyl and 4-hydroxyphenyl.

Examples of the hydroxynaphthyl group include 2,3-dihydroxynaphthyl, 2,4-dihydroxynaphthyl, 2,5-dihydroxynaphthyl, 1,2,3-trihydroxynaphthyl and hydroxynaphthyl.

A hydroxyphenyl group or a hydroxynaphthyl group may have a substituent, and preferred examples of the substituent include alkoxy such as methoxy and ethoxy.

In Formula EV-1, L is a divalent linking group and preferably alkylene, arylene, heteroarylene, -O-, -C(=O)-, -C(=O)O-, -C(=O)-NH-, -NH-C(=O)-, -NH-C(=O)-O-, -O-C(=O)-NH-, -NH-C(=O)-NH-, -NH-C(=S)-NH-, -S(=O)-, -S(=O)₂-, -CH=N-, -NH-NH-, or a group represented by any of these bonds.

The alkylene, arylene or heteroarylene may have a substituent, and examples of the substituent include alkyl, hydroxy, amino, monoalkylamino, dialkylamino, alkoxy and a phosphonic acid group or a salt thereof.

L is more preferably alkylene, arylene or heteroarylene and still more preferably -CH₂-, -CH₂-CH₂-, -CH₂-CH₂-CH₂-, or phenylene.

It is more preferable that the constitutional unit of Formula EV-1 is a constitutional unit of Formula EV-1A. 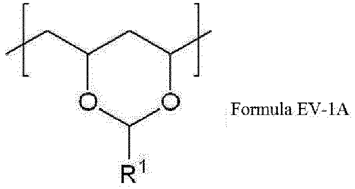 wherein R¹ has the same definition as in Formula EV-1 and the preferable aspects thereof are the same as described above.

In Formula EV-2, R² and R³ each independently are H, halogen, an optionally substituted aromatic or heteroaromatic ring, or an optionally substituted linear, branched or cyclic alkyl or alkenyl group.

Examples of the alkyl group include methyl, ethyl, n-propyl, n-butyl, n-pentyl, n-hexyl, chloromethyl, trichloromethyl, isopropyl, isobutyl, isopentyl, neopentyl, 1-methoxybutyl, isohexyl, cyclopropyl, cyclobutyl, cyclopentyl, cyclohexyl and methylcyclohexyl.

Examples of the alkenyl group include ethenyl, n-propenyl, n-butenyl, n-pentenyl, n-hexenyl, isopropenyl, isobutenyl, isopentenyl, neopentenyl, 1-methylbutenyl, isohexenyl, cyclopentenyl, cyclohexenyl and methylcyclohexenyl.

Examples of the halogen atom include chlorine.

Preferred examples of the aromatic ring include an aryl group such as phenyl, benzyl, tolyl, o-, m-, or p-xylyl, naphthyl, anthracenyl or phenanthrenyl.

Examples of the heteroaromatic ring include furyl, pyridyl, pyrimidyl, pyrazoyl and thiophenyl.

R² and R³ preferably each independently are, Cl or methyl and more preferably H.

Examples of the substituent in the alkyl, alkenyl, or the aromatic or heteroaromatic ring include alkoxy such as methoxy or ethoxy, thioalkyl and -SH.

The aromatic or heteroaromatic ring may contain aryloxy, thioaryl, azo such as an azoalkyl or an azoaryl, or amino, as a substituent.

It is more preferable that the constitutional unit of Formula EV-2 is a constitutional unit of Formula EV-2A. 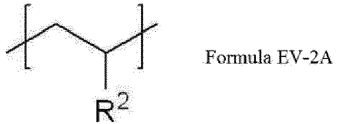 wherein R² has the same definition as in Formula EV-2 and the preferable aspects thereof are the same as described above.

The content of the constitutional unit (here, converted in the monomer unit) of Formula EV-1 is preferably ≥ 10 mol%, more preferably 10-55 mol%, still more preferably 15-45 mol%, and particularly preferably 20-35 mol% with respect to the total amount of the monomer units in the polymer compound 2-2.

The content of the constitutional unit (here, converted in the monomer unit) of Formula EV-2 is preferably ≥ 15 mol, more preferably 15-60 mol%, still more preferably 20-50 mol%, and particularly preferably 25-45 mol% with respect to the total amount of the monomer units in the polymer compound 2-2.

Further, the total content of the constitutional unit of Formula EV-1 and the constitutional unit of Formula EV-2 (here, converted in the monomer unit) is preferably 50-90 mol%, more preferably 60-80 mol%, and still more preferably 65-75 mol% with respect to the total amount of the monomer units in the polymer compound 2-2.

### - Other constitutional units -

The polymer compound 2-2 may contain constitutional units other than the constitutional unit of Formula EV-1 and the constitutional unit of Formula EV-2.

Examples of other constitutional units include a constitutional unit derived from vinyl alcohol which is of Formula EV-3 and a constitutional unit of Formula EV-4. 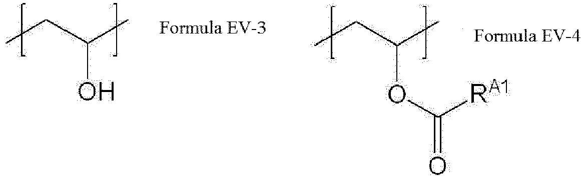 wherein R^{A1} H, optionally substituted linear, branched, or cyclic alkyl, or an optionally substituted aromatic or heteroaromatic ring .

Examples of the substituent in the alkyl group, aromatic ring, or heteroaromatic ring include alkoxy such as methoxy or ethoxy, thioalkyl and -SH.

Further, examples of the substituent in the aromatic ring or heteroaromatic ring aryloxy group include aryloxy, thioaryl, azo and amino.

The content of the constitutional unit (here, converted in the monomer unit) of Formula EV-3 is preferably 10-60 mol%, more preferably 15-50 mol%, and still more preferably 20-30 mol% with respect to the total amount of the monomer units in the polymer compound 2-2.

The content of the constitutional unit (here, converted in the monomer unit) of Formula EV-4 is preferably 0-10 mol%, more preferably < 8 mol%, still more preferably ≥ 0% and < 3 mol%, and particularly preferably ≥ 0 mol% and < 1 mol% with respect to the total amount of the monomer units in the polymer compound 2-2.

Further, as the polymer compound 2-2, polyvinyl acetal of Formula VA is preferable: 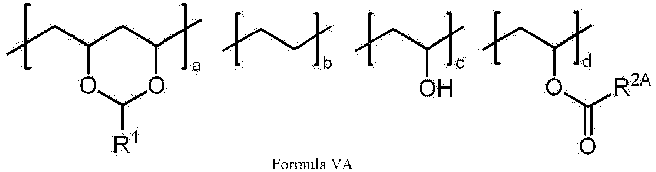 wherein R¹ is an aromatic or heteroaromatic ring containing at least one hydroxyl group, R^{2A} is optionally substituted alkyl, a represents 10-55 mol%, b represents 15-60 mol%, c represents 10-60 mol% and d represents 0-10 mol%.

R¹ has the same definition as in Formula EV-1 and the preferable aspects thereof are the same as described above. R^{2A} is alkyl which may have a substituent and preferably a methyl group.

In Formula VA, a represents preferably 20-50 mol% and more preferably 25-45 mol%, b represents preferably 15-45 mol% and more preferably 20-35 mol%, c represents preferably 15-50 mol% and more preferably 20-30 mol%, and d represents preferably ≥ 0% and < 3 mol% and more preferably ≥ 0% and < 1 mol%.

Hereinafter, specific examples of the polymer compound 2-2 which is preferably used in the present disclosure will be described. In the specific example, Mn represents the number average molecular weight.

Further, the compounds in the following specific examples are not block copolymers but random copolymers randomly having constitutional units delimited by [ ].

Further, in the following examples, Me is methyl.

| | |
|---|---|
| 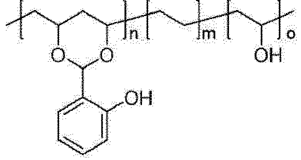 | PE-1 |
| | n/m/o = 40/30/30 (mol%) |
| | Mn 99,600 |
| 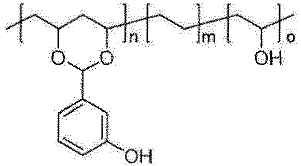 | PE-2 |
| | n/m/o = 38/33/29 (mol%) |
| | Mn 109,000 |
| 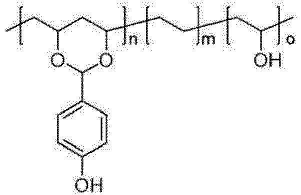 | PE-3 |
| | n/m/o = 38/29/33 (mol%) |
| | Mn 115,000 |
| 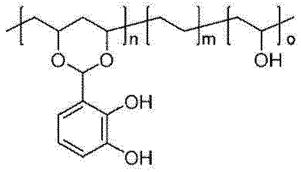 | PE-4 |
| | n/m/o = 38/28/34 (mol%) |
| | Mn 138,000 |
| 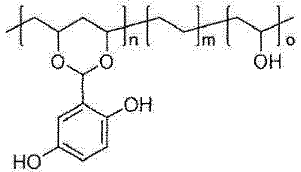 | PE-5 |
| | n/m/o = 38/30/32 (mol%) |
| | Mn 104,000 |
| 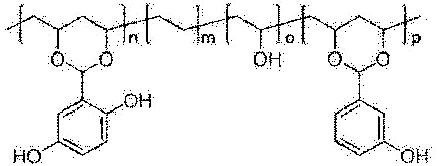 | PE-6 |
| | n/m/o/p = 20/30/30/20 (mol%) |
| | Mn 98,800 |
| 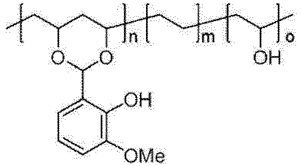 | PE-7 |
| | n/m/o = 40/30/30 (mol%) |
| | Mn 105,000 |

| | |
|---|---|
| 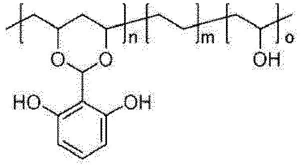 | PE-8 |
| | n/m/o = 38/28/34 (mol%) |
| | Mn 99,600 |
| 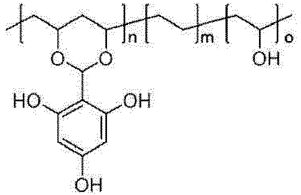 | PE-9 |
| | n/m/o = 42/30/28 (mol%) |
| | Mn 110,600 |
| 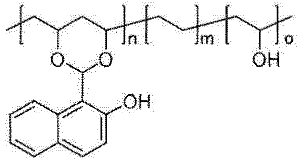 | PE-10 |
| | n/m/o = 40/30/30 (mol%) |
| | Mn 105,000 |
| 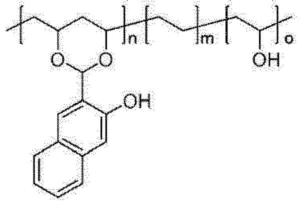 | PE-11 |
| | n/m/o = 40/30/30 (mol%) |
| | Mn 111,000 |
| 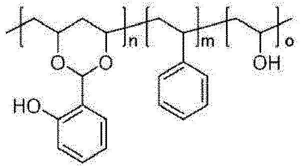 | PE-12 |
| | n/m/o = 40/25/35 (mol%) |
| | Mn 85,600 |
| 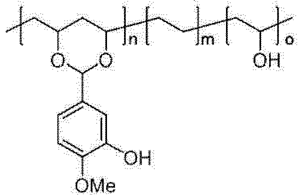 | PE-13 |
| | n/m/o = 40/30/30 (mol%) |
| | Mn 98,800 |
| 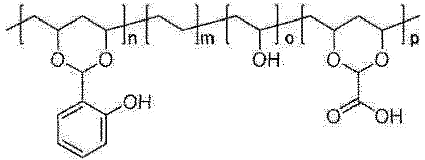 | PE-14 |
| | n/m/o/p = 30/30/30/10 (mol%) |
| | Mn 102,000 |

| | |
|---|---|
| 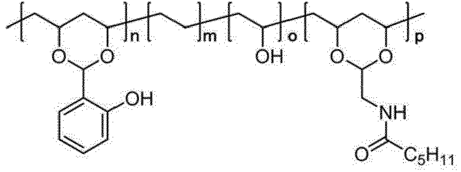 | PE-15 |
| | n/m/o/p = 35/30/30/5 (mol%) |
| | Mn 108,000 |
| 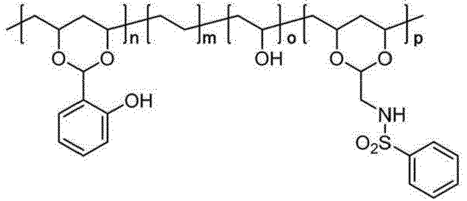 | PE-16 |
| | n/m/o/p = 35/30/30/5 (mol%) |
| | Mn 98,000 |
| 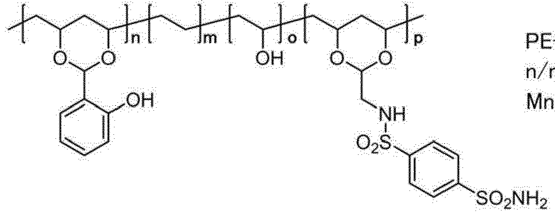 | PE-17 |
| | n/m/o/p = 35/30/30/5 (mol%) |
| | 99,000 |
| 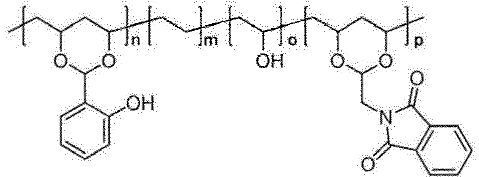 | PE-18 |
| | n/m/o/p = 35/30/30/5 (mol%) |
| | Mn 102,000 |
| 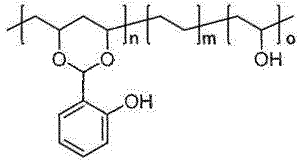 | PE-19 |
| | n/m/o = 35/35/30 (mol%) |
| | Mn 105,000 |

The number average molecular weight (Mn) of the polymer compound 2-2 used in the present disclosure is preferably ≥ 1,500, more preferably 3,000-300,000, and still more preferably 10,000-150,000.

The polymer compound 2-2 may contain constitutional units other than the constitutional units of Formulae EV-1 and EV-2.

Examples of other constitutional units include constitutional units described in US 5,169,897, WO 1993/003068, US 5,534,381, US 5,698,360, JP-A-1999-212252, JP-A-1999-231535, JP-A-2000-039707, JP-A-2000-275821, JP-A-2000-275823, US 6,087,066, WO 2001/009682, US 6,270,938, US 6,596,460, WO 2002/073315, WO 2002/096961, US 6,818,378, WO 2004/20484, WO 2007/003030, WO 2009/005582 and WO 2009/099518.

The polymer compound 2-2 can be prepared using known starting materials and reaction conditions.

Examples of the method of preparing the polymer compound 2-2 include methods described in US 6,541,181, US 4,665,124, US 4,940,646, US 5,169,898, US 5,700,619, US 5,792,823, US 5,849,842, WO 93/003068, DE-B-10011096, DE-B-3404366, US-A-09/751660, WO 01/009682, WO 03/079113, WO 2004/081662, WO 2004/020484, WO 2008/103258 and JP-A-1997-328519.

### - Content -

In a case where the image recording layer according to the present disclosure contains the polymer compound 2-2, the content of the polymer compound 2-2 is preferably 10-90 mass%, more preferably 20-80 mass%, and still more preferably 30-80 mass% with respect to the total mass of the image recording layer.

### [Infrared absorbent]

The image recording layer according to the present disclosure contains an infrared absorbent.

The infrared absorbent is not particularly limited as long as it is a dye which generates heat by absorbing infrared light, and various dyes known as an infrared absorbent can be used.

Examples of the infrared absorbent which can be used in the present disclosure include the infrared absorbents described in paragraphs [0075]-[0085] of WO 2016/047392.

Among these dyes, examples of a particularly preferable dye include a cyanine coloring agent, a phthalocyanine dye, an oxonol dye, a squarylium coloring agent, a pyrylium salt, a thiopyrylium dye, and a nickel thiolate complex. Furthermore, it is most preferable that a cyanine coloring agent of the following Formula (a) is used for the upper layer of the present printing plate precursor from the viewpoint that the dissolution suppressing action is satisfactorily released due to exposure and stability and economic efficiency are excellent.

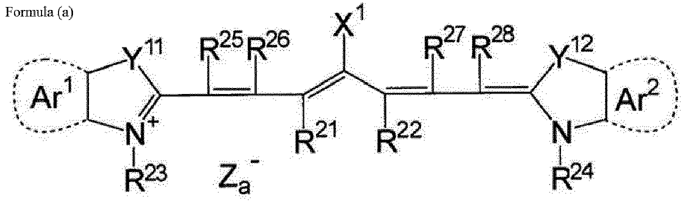

In Formula (a), X¹ is H, halogen, diarylamino, X²-L¹, or a group of Formula (b). X² is O or S, and L¹ is a C₁₋₁₂-hydrocarbon group, an aromatic ring having a heteroatom, or a C₁₋₁₂-hydrocarbon including a heteroatom. Here, the heteroatom is N, S, O, halogen or Se.

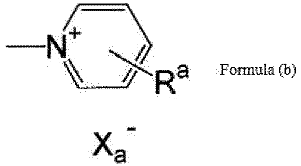

In Formula (b), Xa⁻ has the same definition as Za⁻ described below, and R^{a} is a substituent selected from H, alkyl, aryl, optionally substituted amino and halogen.

R²¹ and R²² each independently are a C₁₋₁₂-hydrocarbon group. From the viewpoint of storage stability of the positive type planographic printing plate precursor, each of R²¹ and R²² is preferably a hydrocarbon group having two or more carbon atoms, and R²¹ and R²² are particularly preferably bonded to each other to form a 5- or 6-membered ring.

Ar¹ and Ar² each independently are an aromatic hydrocarbon group which may have a substituent. Examples of a preferable aromatic hydrocarbon group include a benzene ring and a naphthalene ring. In addition, preferred examples of the substituent include a C₁₋₁₂-hydrocarbon group, halogen, and C₁₋₁₂-alkoxy.

Y¹¹ and Y¹² each independently are S or a dialkyl methylene group having 3-12 carbon atoms. R²³ and R²⁴ each independently are a C₁₋₂₀-hydrocarbon group which may have a substituent. Preferred examples of the substituent include C₁₋₁₂-alkoxy, carboxyl and a sulfo group.

R²⁵-R²⁸ each independently are H or a C₁₋₁₂-hydrocarbon group. From the viewpoint of availability of a raw material, it is preferable that R²⁵-R²⁸ each are H. In addition, Za⁻ represents a counter anion. Here, the cyanine coloring agent of Formula (a) has an anionic substituent in the structure thereof, and in a case where neutralization of the charge is not necessary, Za⁻ is not necessary. From the viewpoint of storage stability of the positive type planographic printing plate precursor, Za⁻ represents preferably a halide ion, a perchlorate ion, a tetrafluoroborate ion, a hexafluorophosphate ion, or a sulfonic acid ion and particularly preferably a perchlorate ion, a hexafluorophosphate ion, or an arylsulfonic acid ion.

Specific examples of the cyanine coloring agent of Formula (a) which can be suitably used include the cyanine coloring agents described in paragraphs [0017]-[0019] of JP-A-2001-133969, paragraphs [0012]-[0038] of JP-A-2002-040638 and paragraphs [0012]-[0023] of JP-A-2002-023360. It is particularly preferable that the infrared absorbent contained is a cyanine dye A shown below.

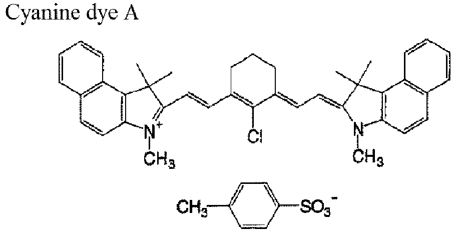

The content of the infrared absorbent in the image recording layer according to the present disclosure is preferably 0.01-50 mass%, more preferably 0.1-30 mass%, and particularly preferably 1.0-30 mass%, with respect to the total mass of the image recording layer. In a case where the content thereof is ≥ 0.01 mass%, the layer becomes highly sensitive, and in a case where the content thereof is ≤ 50 mass%, the uniformity of the layer is excellent and the durability of the layer is excellent.

### [Other alkali-soluble resins]

The image recording layer according to the present disclosure may contain alkali-soluble resins other than the polymer compound 1 and the polymer compound 2-2.

In the present disclosure, the "alkali-soluble" means that "0.01 g of a resin is dissolved in 5 g of a sodium hydroxide aqueous solution having a pH of 13.0 at 30°C within 200 seconds. Further, the dissolution indicates is a state in which the residual of a dissolved substance cannot be visually confirmed.

Although other alkali-soluble resins used in the image recording layer of the present disclosure is not particularly limited as long as the resin has a characteristic of being dissolved by contact with an alkaline developer, it is preferable that the alkali-soluble resin has an acidic functional group such as a sulfonic acid group, a phosphoric acid group, a sulfonamide group, or an active imide group in at least one of the main chain or a side chain in the polymer, a resin including ≥ 10 mol% of a monomer having such an acidic functional group imparting alkali-solubility is exemplified, and a resin including ≥ 20 mol% is more preferable. In a case where the copolymerization component of the monomer imparting alkali-solubility is ≥ 10 mol%, sufficient alkali-solubility is obtained, and developability is excellent.

In addition, as other alkali-soluble resin, a novolac resin is also preferably exemplified.

Preferred examples of the novolac resin which can be used in the image recording layer of the present disclosure, novolac resins such as a phenol formaldehyde resin, an m-cresol formaldehyde resin, a p-cresol formaldehyde resin, an m-/p- mixed cresol formaldehyde resin, a phenol/cresol (which may be any mixture of m-, p-, or m-/p-) mixed formaldehyde resin or pyrogallol acetone resins are preferably exemplified.

In addition, a polycondensate of phenol having an alkyl group having 3 to 8 carbon atoms as a substituent and formaldehyde, such as a t-butyl phenol formaldehyde resin or an octyl phenol formaldehyde resin, as described in US 4,123,279, is exemplified. In addition, the weight-average molecular weight (Mw) thereof is preferably ≥ 500, and more preferably 1,000-700,000. In addition, the number average molecular weight (Mn) thereof is preferably ≥ 500, and more preferably 750-650,000. The dispersity (weight-average molecular weight/number average molecular weight) is preferably 1.1-10.

Other alkali-soluble resins preferably have a weight-average molecular weight of ≥ 2,000 and a number average molecular weight of ≥ 500, and more preferably have a weight-average molecular weight of 5,000-300,000 and a number average molecular weight of 800-250,000. The dispersity (weight-average molecular weight/number average molecular weight) of other alkali-soluble resins is preferably 1.1-10.

Other alkali-soluble resins included in the image recording layer according to the present disclosure as desired may be used alone or in combination of two or more kinds thereof.

The content of other alkali-soluble resins in the image recording layer according to the present disclosure is preferably 0-80 mass% and more preferably 0-70 mass% with respect to the total mass of the image recording layer. In addition, the proportion of other alkali-soluble resin is preferably ≤ 80 parts by mass (pbm) with respect to 100 pbm which is the total amount of the polymer compounds 1 and 2 used in the image recording layer according to the present disclosure.

### [Acid generator]

It is preferable that the image recording layer according to the present disclosure contains an acid generator from the viewpoint of improving the sensitivity.

The acid generator in the present disclosure is a compound which generates an acid by light or heat, and indicates a compound which generates an acid due to decomposition by irradiation with infrared rays or heating at ≥ 100°C. The acid generated is preferably a strong acid having a pKa of ≤ 2 such as sulfonic acid or hydrochloric acid. The permeability of a developer into the image recording layer of the exposed portion is increased and the solubility of the image recording layer in an alkali aqueous solution is further improved due to an acid generated from this acid generator.

Examples of the acid generator which is suitably used in the image recording layer according to the present disclosure include the acid generators described in paragraphs [0116]-[0130] ofWO 2016/047392.

Among these, from the viewpoint of sensitivity and stability, an onium salt compound is preferably used as an acid generator. The onium salt compound will be described below.

As the onium salt compound which can be suitably used in the image recording layer according to the present disclosure, compounds known as a compound which generates an acid due to decomposition by infrared ray exposure or heat energy generated from the infrared absorbent by exposure can be exemplified. As the onium salt compound suitable in the image recording layer according to the present disclosure, from the viewpoint of sensitivity, known thermal polymerization initiators or compounds having a bond with small bond dissociation energy and having an onium salt structure described below can be exemplified.

Examples of the onium salt suitably used in the image recording layer according to the present disclosure include known diazonium salts, iodonium salts, sulfonium salts, ammonium salts, pyridinium salts, and azinium salts, and among these, sulfonate of triarylsulfonium or diaryliodonium, carboxylate, BF₄⁻, PF₆⁻, or ClO₄⁻ is preferable.

Examples of the onium salt which can be used as an acid generator in the image recording layer of the present printing plate precursor include onium salts of the Formulae (III) to (V): 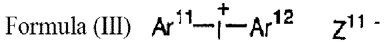 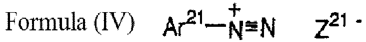 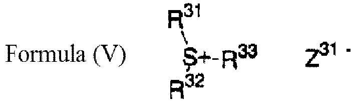 wherein Ar¹¹ and Ar¹² each independently are optionally substituted C₆₋₂₀-aryl gr. Examples of a preferable substituent in a case where the aryl group has a substituent include halogen, nitro, C₁₋₁₂-, C₁₋₁₂-alkoxy and C₁₋₁₂-aryloxy. Z¹¹⁻ is a counter ion selected from a halide ion, a perchlorate ion, a tetrafluoroborate ion, a hexafluorophosphate ion, a sulfonic acid ion, or a sulfonic acid ion having a fluorine atom such as a perfluoroalkyl sulfonic acid ion, and a perchlorate ion, a hexafluorophosphate ion, an aryl sulfonic acid ion, or a perfluoroalkyl sulfonic acid is preferable.

In Formula (IV), Ar²¹ is optionally substituted C₆₋₂₀-. Examples of a preferable substituent include halogen, nitro, C₁₋₁₂-alkyl, C₁₋₁₂-alkoxy, C₁₋₁₂-aryloxy, C₁₋₁₂-alkylamino, C₂₋₁₂-dialkylamino, C₆₋₁₂-arylamino and diarylamino group (each independently having 6-12 carbon atoms in the aryl group). Z²¹⁻ is a counter ion having the same definition as Z¹¹⁻.

In Formula (V), R³¹-R³³ each independently are an optionally substituted C₁₋₂₀-hydrocarbon group. Examples of a preferable substituent include halogen, nitro, C₁₋₁₂-alkyl, C₁₋₁₂-alkoxy and C₁₋₁₂-aryloxy. Z³¹⁻ is a counter ion having the same definition as that for Z¹¹⁻.

Specific examples of the onium salt which can be suitably used in the image recording layer according to the present disclosure are the same as the compounds described in paragraphs [0121]-[0124] of WO 2016/047392.

In addition, as another example of the compounds of each of Formula (III) to (V), the compounds described as an example of a radical polymerization initiator in paragraphs [0036]-[0045] of JP-A-2008-195018 can be suitably used as an acid generator in the image recording layer according to the present disclosure.

More preferred examples of the acid generator which can be used in the image recording layer according to the present disclosure include compounds of Formulae PAG-1 to PAG-5. Further, in Formulae PAG-1 to PAG-5, Me is methyl.

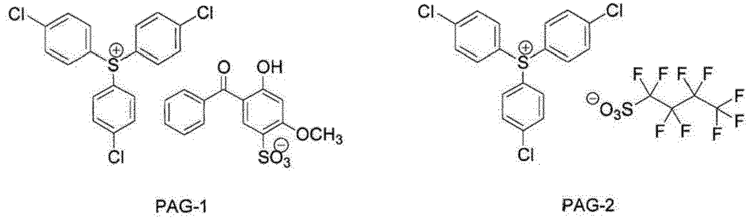

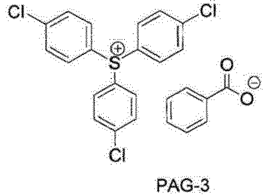

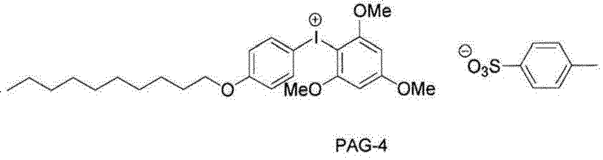

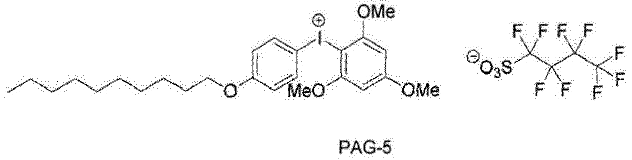

In a case where these acid generators are contained in the image recording layer according to the present disclosure, these compounds may be used alone or in combination of two or more kinds thereof.

The content of acid generator is preferably 0.01-50 mass%, more preferably 0.1-40 mass%, and still more preferably 0.5-30 mass% with respect to the total mass of the image recording layer. In a case where the content is within the above-described range, improvement of sensitivity which is the effect of the addition of an acid generator is observed, and an occurrence of a residual film in a non-image area is suppressed.

### [Acid proliferation agent]

An acid proliferation agent may be contained in the image recording layer according to the present disclosure. The acid proliferation agent in the image recording layer according to the present disclosure is a compound substituted with a residue of a relatively strong acid, and a compound which newly generates an acid by being easily released in the presence of an acid catalyst. That is, the compound is decomposed by an acid catalyzed reaction, and generates an acid again. Since one or more acids per reaction are increased, and with the progress of the reaction, the acid concentration is increasingly increased, sensitivity is dramatically improved. The intensity of this generated acid preferably is ≤ 3 as an acid dissociation constant (pKa) and more preferably ≤ 2. In a case where the intensity of the acid is ≤ 3 as an acid dissociation constant, the elimination reaction using an acid catalyst is likely to be caused.

Examples of the acid used in such an acid catalyst include dichloroacetic acid, trichloroacetic acid, methanesulfonic acid, ethanesulfonic acid, benzenesulfonic acid, p-toluenesulfonic acid, naphthalenesulfonic acid, and phenyl sulfonic acid.

Examples of the acid proliferation agent which can be used are the same as those described in paragraphs [0133]-[0135] of WO 2016/047392.

The content of the acid proliferation agent is 0.01-20 mass%, preferably 0.01-10 mass%, and more preferably 0.1-5 mass% with respect to the total mass of the image recording layer according to the present disclosure. In a case where the content of the acid proliferation agent is in the above-described range, effects of adding acid proliferation agent are sufficiently obtained, improvement in sensitivity is achieved, and film hardness reduction of an image area is suppressed.

### [Other additives]

The image recording layer according to the present disclosure may include a development accelerator, a surfactant, a print-out agent/colorant, a plasticizer, or a wax agent, as other additives. As other additives, those described in paragraphs [0138]-[0142] of WO 2016/047392 can be used.

### [Compositional ratio of respective components]

The content of the polymer compound 1 is preferably 10-90 mass%, the content of the polymer compound 2-1 or the polymer compound 2-2 is preferably in a range of 10-90%, the content of the infrared absorbent is preferably in a range of 0.01-50 mass%, the content of other alkali-soluble resins is preferably 0-80 mass%, the content of the acid generator is preferably 0-30 mass%, the content of the acid proliferation agent is preferably 0-20 mass%, the content of the development accelerator is preferably 0-20 mass%, the content of the surfactant is preferably 0-5 mass%, the content of the print-out agent/colorant is preferably 0-10 mass%, the content of the plasticizer is preferably 0-10%, and the content of the wax agent is preferably 0-10 mass%, with respect to the total mass of the image recording layer according to the present disclosure.

The content ratio (mass ratio) between the polymer compound 1 and the polymer compound 2-2 (polymer compound 1: polymer compound 2-2) which are contained in the image recording layer of the present disclosure is preferably in a range of 1:5 to 5:1 and more preferably in a range of 1:3 to 3:1.

### [Upper layer and lower layer]

It is preferable that the present printing plate precursor includes a recording layer having a lower layer and an upper layer in this order, on the support having a hydrophilic surface, and at least one of the lower layer or the upper layer is the image recording layer (the image recording layer containing the polymer compound 1, the polymer compound 2-2, and the infrared absorbent, and also referred to as the "present image recording layer").

The positive type planographic printing plate precursor having the lower layer and the upper layer is also referred to as a "printing plate precursor having a two-layer structure".

In the present disclosure, the recording layer indicates a layer whose solubility in an alkali aqueous solution is changed due to heat. It is preferable that both of the lower layer and the upper layer are recording layers.

In a case where any one of the lower layer or the upper layer is the present image recording layer, it is preferable that the other layer is another recording layer.

Another recording layer indicates a recording layer whose composition is different from the composition of the present image recording layer, and it is preferable that another layer is a recording layer whose solubility in an alkali aqueous solution is improved due to heat.

In the present printing plate precursor, from the viewpoint of the printing durability in a case where a particularly low-quality material such as paper or ink is used, it is preferable that the lower layer is the present image recording layer and the upper layer is another recording layer.

The detailed mechanism for obtaining the above-described effect is not clear, but it is assumed that the film hardness of the resin used in the lower layer is important for the printing durability in printing. Therefore, in the present image recording layer, it is speculated that the printing durability is improved by using the present image recording layer as the lower layer because the interaction (such as a hydrogen bond) between binders is strong.

### - Formation of lower layer and upper layer -

It is preferable that the lower layer and the upper layer are separately formed.

As the method of separately forming the two layers, for example, a method of using the difference in the solvent solubilities between the components included in the lower layer and the components included in the upper layer and a method of rapidly drying and removing the solvent after application to the upper layer are exemplified. Since by using the latter method in combination, the separation between the layers is more favorably performed, the method is preferable.

These methods will be described in detail below, but the method of separately applying to the two layers is not limited thereto.

In the method of using the difference in the solvent solubilities between the components included in the lower layer and the components included in the upper layer, in a case where applying a coating solution for an upper layer, a solvent system in which all the components included in the lower layer are insoluble is used. Thus, even in a case where two-layer coating is performed, a coated film can be formed such that each layer thereof is clearly separated. For example, by selecting a component insoluble in a solvent such as methyl ethyl ketone or 1-methoxy-2-propanol which dissolves an alkali-soluble resin which is the upper layer component, as the lower layer component, applying to the lower layer and drying using a solvent system which dissolves the lower layer component, dissolving the alkali-soluble resin-based upper layer in methyl ethyl ketone or 1-methoxy-2-propanol, and applying the resulting product and drying, bilayering is possible.

Next, the method of very rapidly drying the solvent after application to the second layer (upper layer) can be achieved by blowing high-pressure air from a slit nozzle provided substantially at a right angle with respect to the running direction of the web, applying heat energy as conductive heat from the lower surface of the web by a roll (heating roll) into which a heating medium such as steam has been supplied, or combining these.

The coating amount after drying of the lower layer components to be applied to the support of the present printing plate precursor is preferably 0.5-4.0 g/m² and more preferably 0.6-2.5 g/m². In a case where the coating amount is ≥ 0.5 g/m², printing durability is excellent, and in a case where the coating amount is ≤ 4.0 g/m², image reproducibility and sensitivity are excellent.

In addition, the coating amount after drying of the upper layer component is preferably 0.05-1.0 g/m² and more preferably 0.08-0.7 g/m². In a case where the coating amount is ≥ 0.05 g/m², development latitude and scratch resistance are excellent, and in a case where the coating amount is ≤ 1.0 g/m², sensitivity is excellent.

The coating amount after drying of the lower layer and the upper layer is preferably 0.6 to 4.0 g/m² and more preferably 0.7 to 2.5 g/m². In a case where the coating amount is ≥ 0.6 g/m², printing durability is excellent, and in a case where the coating amount is ≤ 4.0 g/m², image reproducibility and sensitivity are excellent.

### [Upper layer]

The upper layer of the present printing plate precursor having a two-layer structure may be the present image recording layer, but it is preferable that the upper layer thereof is another recording layer.

It is preferable that the upper layer of the present printing plate precursor having a two-layer structure ac is an infrared sensitive positive type recording layer whose solubility in an alkali aqueous solution is improved by heat.

The mechanism of improving the solubility in alkali aqueous solution by heat in the upper layer is not particularly limited, and any one can be used as long as it includes a binder resin and improves the solubility of the heated region. As the heat used in image formation, the heat generated in a case where the lower layer including an infrared absorbent is exposed is exemplified.

Preferable examples of the upper layer of which the solubility in an alkali aqueous solution is improved by heat include a layer including an alkali-soluble resin having a hydrogen-bonding capacity such as a novolac resin or a urethane resin, a layer including a water-insoluble and alkali-soluble resin and a compound having a dissolution suppressing action, and a layer including an ablation-possible compound.

In addition, by further adding an infrared absorbent to the upper layer, the heat generated from the upper layer can also be used in image formation. Preferable examples of the constitution of the upper layer including an infrared absorbent include a layer including an infrared absorbent, a water-insoluble and alkali-soluble resin, and a compound having a dissolution suppressing action, and a layer including an infrared absorbent, a water-insoluble and alkali-soluble resin, and an acid generator.

### - Water-insoluble and alkali-soluble resin -

It is preferable that the present upper layer a contains a water-insoluble and alkali-soluble resin. By containing the water-insoluble and alkali-soluble resin, an interaction is formed between the polar groups of the infrared absorbent and the water-insoluble and alkali-soluble resin, and a layer having a positive type photosensitivity is formed.

Typical water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

The water-insoluble and alkali-soluble resin which can be used in the present disclosure is not particularly limited as long as it has a characteristic of being dissolved by contact with an alkaline developer, and a homopolymer containing an acidic group in the main chain and/or a side chain in the polymer, a copolymer thereof, or a mixture thereof is preferable.

Such a water-insoluble and alkali-soluble resin having an acidic group preferably has a functional group such as a phenolic hydroxyl group, a carboxy group, a sulfonic acid group, a phosphoric acid group, a sulfonamide group, or an active imide group. Therefore, such a resin can be suitably generated by copolymerizing a monomer mixture including one or more ethylenically unsaturated monomers having a functional group described above. As the ethylenically unsaturated monomer having a functional group described above, in addition to acrylic acid and methacrylic acid, a compound of the following formula and a mixture thereof can be preferably exemplified. Moreover, in the following formula, R⁴⁰ is H or methyl.

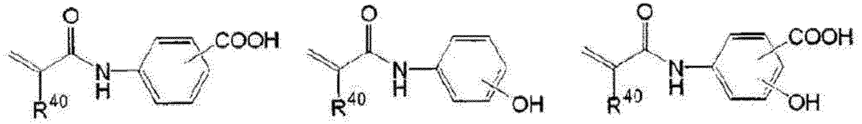

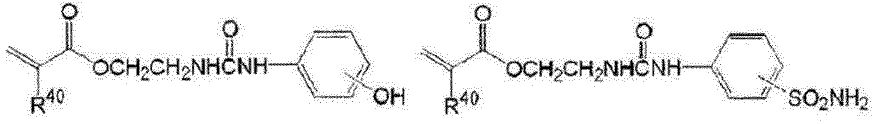

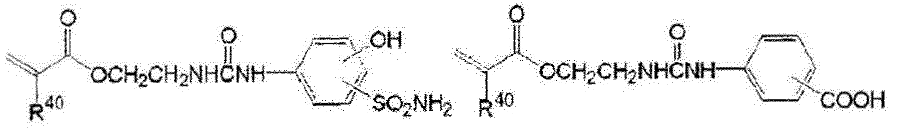

It is preferable that the water-insoluble and alkali-soluble resin which can be used in the present disclosure is a polymer compound obtained by copolymerizing another polymerizable monomer in addition to the above-mentioned polymerizable monomers. As the copolymerization ratio in this case, a monomer imparting alkali-solubility such as a monomer having a functional group such as a phenolic hydroxyl group, a carboxy group, a sulfonic acid group, a phosphoric acid group, a sulfonamide group, or an active imide group is preferably included in ≥ 10 mol%, and more preferably included in ≥ 20 mol%. In a case where the copolymerization component of the monomer imparting alkali-solubility is ≥ 10 mol%, sufficient alkali-solubility is obtained, and developability is excellent.

Examples of other usable polymerizable monomers include compounds exemplified below.

Alkyl acrylates or alkyl methacrylates such as methyl acrylate, ethyl acrylate, propyl acrylate, benzyl acrylate, methyl methacrylate, ethyl methacrylate, cyclohexyl methacrylate, and benzyl methacrylate. Acrylic acid esters or methacrylic acid esters having an aliphatic hydroxyl group such as 2-hydroxyethyl acrylate and 2-hydroxyethyl methacrylate. Acrylamides or methacrylamides such as acrylamide, methacrylamide, N-methylacrylamide, N-ethylacrylamide, and N-phenylacrylamide. Vinyl esters such as vinyl acetate, vinyl chloroacetate, vinyl butyrate, and vinyl benzoate. Styrenes such as styrene, α-methylstyrene, methylstyrene, and chloromethylstyrene. Other nitrogen atom-containing monomers such as N-vinyl pyrrolidone, N-vinyl pyridine, acrylonitrile, and methacrylonitrile. Maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide, and N -hydroxyphenylmaleimide.

Among these other ethylenically unsaturated monomers, (meth)acrylic acid esters, (meth)acrylamides, maleimides, or (meth)acrylonitrile is suitably used.

In addition, as the alkali-soluble resin, a novolac resin exemplified as another alkali-soluble resin described as an optional component of the present image recording layer may also be preferably exemplified.

In addition, the water-insoluble and alkali-soluble resin described above can also be used in the present image recording layer.

Furthermore, in the present upper layer, other resins can be used in combination within a range not impairing the effects of the present printing plate precursor. Since the upper layer is required to express alkali-solubility, in particular, in a non-image area region, it is necessary to select a resin which does not impair this characteristic. From this viewpoint, as a resin usable in combination, a water-insoluble and alkali-soluble resin is exemplified. General water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

In addition, the amount to be mixed is preferably ≤ 50 mass% with respect to the water-insoluble and alkali-soluble resin.

The water-insoluble and alkali-soluble resin preferably has a weight-average molecular weight of ≥ 2,000 and a number average molecular weight of ≥ 500, and more preferably has a weight-average molecular weight of 5,000-300,000 and a number average molecular weight of 800-250,000. The dispersity (weight-average molecular weight/number average molecular weight) of the alkali-soluble resin is preferably 1.1-10.

The alkali-soluble resin in another recording layer of the present disclosure may be used alone or in combination of two or more kinds thereof.

The content of the alkali-soluble resin in another recording layer is preferably 2.0-99.5 mass%, more preferably 10.0-99.0 mass%, and still more preferably 20.0-90.0 mass% with respect to the total mass of another recording layer according to the present disclosure. In a case where the amount of the alkali-soluble resin to be added is ≥ 2.0 mass%, the durability of the recording layer (photosensitive layer) is excellent. Further, in a case where the amount of the alkali-soluble resin to be added is ≤ 99.5 mass%, both the sensitivity and the durability are excellent.

### - Infrared absorbent -

The upper layer may contain an infrared absorbent.

The infrared absorbent is not particularly limited as long as it is a dye which generates heat by absorbing infrared light, and the infrared absorbent used in the present image recording layer, described above, can also be used.

A particularly preferred dye is the cyanine coloring agent of Formula (a).

In a case where the upper layer contains an infrared absorbent, the sensitivity to infrared light becomes excellent.

The amount of the infrared absorbent to be added in the upper layer is preferably 0.01-50 mass%, more preferably 0.1-30 mass%, and particularly preferably 1.0-10 mass% with respect to the total solid content in the upper layer. In a case where the amount of the infrared absorbent to be added is ≥ 0.01 mass%, the sensitivity is improved, and in a case where the amount of the infrared absorbent to be added is ≤ 50 mass%, the uniformity of the layer is excellent and the durability of the layer is excellent.

### - Other components -

In addition, the upper layer of the planographic printing plate precursor having a two-layer structure may include an acid generator, an acid proliferation agent, a development accelerator, a surfactant, a print-out agent/colorant, a plasticizer, or a wax agent.

As these components, respective components used in the present image recording layer, described above, can also be used, and the preferable aspects thereof are the same as described above.

### [Lower layer]

It is preferable that the lower layer of the present printing plate precursor having a two-layer structure is the present image recording layer.

A printing plate with excellent image formability and printing durability can be obtained by using the present image recording layer ac as the lower layer.

In a case where the present image recording layer is used as the upper layer, it is preferable that the lower layer is also the present image recording layer, but the lower layer may be another recording layer. The preferable aspects of the lower layer in this case are the same as the preferable aspects of the upper layer described above.

### <Support having hydrophilic surface>

The support used in the present printing plate precursor is not particularly limited as long as the support is a dimensionally stable plate-shaped material having required strength and durability, and examples thereof include the supports described in paragraphs [0166]-[0169] of WO 2016/047392.

In the description above, an aluminum support is preferable, and an aluminum support to which a hydrophilic treatment has been applied is particularly preferable.

### <Undercoat layer>

It is preferable that the present printing plate precursor includes an undercoat layer between the support having a hydrophilic surface and the image recording layer.

In a case where the present printing plate precursor is a planographic printing plate having a two-layer structure, it is preferable that the precursor includes the support having a hydrophilic surface and an undercoat layer between the support and the lower layer.

As the undercoat layer component, various organic compounds can be used, and preferable examples thereof include phosphonic acids having an amino group such as carboxymethyl cellulose or dextrin, an organic phosphonic acid, an organic phosphorus acid, an organic phosphinic acid, amino acids, and hydrochloride of an amine having a hydroxy group. In addition, these undercoat layer components may be used alone or in a mixture of two or more types thereof. Details of the compound used in the undercoat layer and the method of forming the undercoat layer are described in paragraphs [0171]-[0172] of JP-A-2009-175195, and those described here are also applied to the present disclosure.

The coating amount of the undercoat layer is preferably 2-200 mg/m² and more preferably 5-100 mg/m². In a case where the coating amount is in the above-described range, sufficient printing durability is obtained.

### <Back coat layer>

A back coat layer is provided on the rear surface of the support of the present printing plate precursor, as necessary. As the back coat layer, coating layers formed of an organic polymer compound described in JP-A-1993-045885 or a metal oxide obtained by hydrolyzing and polycondensing an organic or inorganic metal compound described in JP-A-1994-035174 are preferably used. Among these coating layers, alkoxy compounds of silicon such as Si(OCH₃)₄, Si(OC₂H₅)₄, Si(OC₃H₇)₄, and Si(OC₄H₉)₄ are easily available at low cost, and coating layers of metal oxides obtained from these have excellent developer resistance, and thus, these are particularly preferable.

### (Method of producing planographic printing plate)

The present method of producing a planographic printing plate includes image-wise light exposing the planographic printing plate precursor ; and a developing the precursor using an alkali aqueous solution having a pH of 8.5-13.5, in this order.

According to the present method, occurrence of stain caused by the residual film of a non-image area is suppressed and a planographic printing plate with excellent printing durability and chemical resistance is obtained.

Hereinafter, each step of the present method will be described in detail.

### <Exposure step>

The present method includes an exposure step of subjecting the present printing plate precursor to image-wise light exposure. The detailed description is the same as the description in paragraphs [0173]-[0175] of WO 2016/047392.

### <Development step>

The present method includes a development step of performing development using an alkali aqueous solution with a pH of 8.5-13.5 (hereinafter, also referred to as a "developer").

### [Developer]

The developer used in the development step is an aqueous solution having a pH of 8.5-13.5 and more preferably an alkali aqueous solution having a pH of 12-13.5. The surfactant contributes to improvement of the processability.

Further, it is preferable that the developer contains a surfactant and more preferable that the developer contains at least an anionic surfactant or a nonionic surfactant. A surfactant contributes to improvement of processability.

As the surfactant used in the developer, any of an anionic surfactant, a nonionic surfactant, a cationic surfactant, and an amphoteric surfactant can be used, and as described above, an anionic surfactant or a nonionic surfactant is preferable.

As the anionic surfactant, the nonionic surfactant, the cationic surfactant, and the amphoteric surfactant used in the developer according to the present method, the surfactants described in paragraphs [0128]-[0131] of JP-A-2013-134341 can be used.

In addition, from the viewpoint of stable solubility or turbidity in water, a surfactant preferably has a hydrophile-lipophile balance (HLB) value of ≥ 6 and more preferably has a HLB value of ≥ 8.

As the surfactant used in the developer, an anionic surfactant or a nonionic surfactant is preferable, and an anionic surfactant containing sulfonic acid or sulfonate or a nonionic surfactant having an aromatic ring and an ethylene oxide chain is particularly preferable.

The surfactant can be used alone or in combination.

The content of the surfactant in the developer is preferably 0.01-10 mass%, and more preferably 0.01-5 mass%.

In a case where as a buffer, carbonate ions and hydrogencarbonate ions are included to maintain the pH of the developer at 8.5-13.5, it is possible to suppress variations in pH even in a case where the developer is used for a long period of time, and it is possible to suppress developability deterioration and a development scum occurrence due to the variation in pH. To make carbonate ions and hydrogencarbonate ions present in the developer, carbonate and hydrogencarbonate may be added to the developer, or by adjusting the pH after carbonate or hydrogencarbonate is added, carbonate ions and hydrogencarbonate ions may be generated. Although carbonate and hydrogencarbonate are not particularly limited, an alkali metal salt is preferable. Examples of the alkali metal include lithium, sodium, and potassium, and sodium is particularly preferable. These may be used alone or in combination of two or more types thereof.

The total amount of carbonate and hydrogencarbonate is preferably 0.3-20 mass%, more preferably 0.5-10 mass%, and particularly preferably 1-5 mass%, with respect to the total mass of the developer. In a case where the total amount is ≥ 0.3 mass%, developability and processing capability are not reduced, and in a case where the total amount is ≤ 20 mass%, a precipitate or a crystal is less likely to be generated and at the time of the waste liquid treatment of the developer, gelation during neutralization is less likely to occur, and thus, trouble does not occur in the waste liquid treatment.

After the development step, a continuous or discontinuous drying step is preferably performed. Drying is performed by hot air, infrared rays, or far infrared rays.

As an automatic treatment machine suitably used for the present method, a device having a developing unit and a drying unit is used, and a planographic printing plate is obtained by performing development and gumming on the positive type planographic printing plate precursor in a developer tank and drying the positive type planographic printing plate precursor in the drying unit.

In addition, for the purpose of e.g. improving printing durability, it is also possible to heat the printing plate after developing in very strong conditions. The heating temperature is preferably 200-500°C. In a case where the temperature is low, sufficient image strengthening effects are not obtained, and in a case where the temperature is too high, there is a possibility that problems such as deterioration of the support or thermal decomposition of the image area occur.

The planographic printing plate obtained in this manner is mounted on an offset printing machine, and can be suitably used in printing a large number of sheets.

Hereinafter, the present invention will be described in detail based on examples. The materials, the used amounts, the proportions, the treatment contents, and the treatment procedures described in the following examples can be appropriately changed within the range not departing from the scope of the embodiment of the present invention. Therefore, the range of the embodiment of the present invention is not limited to the following specific examples. Moreover, "part" and "%" in the present examples respectively represent "part(s) by mass" and "% by mass" unless otherwise specified.

Hereinafter, compounds PU-1 to PU-20, PT-1 to PT-20, PC-1 to PC-14, and PE-1 to PE-19 in examples each correspond to the compounds PU-1 to PU-20, PT-1 to PT-20, PC-1 to PC-14, and PE-1 to PE-19 in the specific examples described above.

### (Examples)

### <Synthesis of compounds PU-1 to PU-20, c PT-1 to PT-20 and PC-1 to PC-14>

The compounds PU-1 to PU-20, PT-1 to PT-20 and PC-1 to PC-14 were synthesized with reference to the method described in WO 2016/133072,the compounds PA-1 to PA-12 were synthesized with reference to the method described in EP-B-1826001, and the compounds PE-1 to PE-12 were synthesized with reference to the method described in WO 2014/106554.

### <Preparation of support>

An aluminum alloy plate having a thickness of 0.3 mm of a material IS was subjected to the following (A-a) to (A-k) treatments, thereby producing a support for a planographic printing plate. Moreover, during all treatment steps, a washing treatment with water was performed, and after the washing treatment with water, liquid cutting was performed using a nip roller.

### (A-a) Mechanical roughening treatment (brush grain method)

While supplying a suspension of pumice (specific gravity of 1.1 g/cm³) to the surface of an aluminum plate as a polishing slurry liquid, a mechanical roughening treatment was performed using rotating bundle bristle brushes.

The median diameter (µm) of a polishing material was 30 µm, the number of the brushes was four, and the rotation speed (rpm) of the brushes was set to 250 rpm. The material of the bundle bristle brushes was nylon-6,10, the diameter of the brush bristles was 0.3 mm, and the bristle length was 50 mm. The brushes were produced by implanting bristles densely into the holes in a stainless steel cylinder having φ300 mm. The distance between two support rollers (φ200 mm) of the lower portion of the bundle bristle brush was 300 mm. The bundle bristle brushes were pressed until the load of a driving motor for rotating the brushes became 10 kW plus with respect to the load before the bundle bristle brushes were pressed against the aluminum plate. The rotation direction of the brushes was the same as the moving direction of the aluminum plate.

### (A-b) Alkali etching treatment

The aluminum plate obtained above was subjected to an etching treatment by spraying a caustic soda aqueous solution in which the concentration of caustic soda was 26 mass% and the concentration of aluminum ions was 6.5 mass using a spray tube at a temperature of 70°C. Thereafter, washing with water by spraying was performed. The amount of aluminum dissolved was 10 g/m².

### (A-c) Desmutting treatment in acidic aqueous solution

Next, a desmutting treatment was performed in a nitric acid aqueous solution. As the nitric acid aqueous solution used in the desmutting treatment, the waste liquid of nitric acid used in electrochemical roughening of the next step was used. The liquid temperature was 35°C. The desmutting treatment was performed for 3 seconds by spraying the desmutting liquid using a spray.

### (A-d) Electrochemical roughening treatment

An electrochemical roughening treatment was continuously performed using an AC voltage of nitric acid electrolysis 60 Hz. As the electrolyte at this time, an electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp until the current value reached a peak from zero of 0.8 ms and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and 5% of the current from the power source was separately flowed to the auxiliary anode. The electric quantity (C/dm²) was 185 C/dm² as the sum total of electric quantity at the time of anodization of the aluminum plate. Thereafter, washing with water by spraying was performed.

### (A-e) Alkali etching treatment

The aluminum plate obtained above was subjected to an etching treatment by spraying a caustic soda aqueous solution in which the concentration of caustic soda was 5 mass% and the concentration of aluminum ions was 0.5 mass% using a spray tube at a temperature of 50°C. Thereafter, washing with water by spraying was performed. The amount of aluminum dissolved was 0.5 g/m².

### (A-f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The liquid temperature was 30°C. The desmutting treatment was performed for 3 seconds by spraying the desmutting liquid using a spray.

### (A-g) Electrochemical roughening treatment

An electrochemical roughening treatment was continuously performed using an AC voltage of hydrochloric acid electrolysis 60 Hz. As the electrolyte, an electrolyte which had been adjusted to have a concentration of aluminum ions of 4.5 g/L by adding aluminum chloride to a hydrochloric acid aqueous solution having a concentration of 6.2 g/L at a liquid temperature of 35°C was used. Using a trapezoidal rectangular waveform AC having a time tp until the current value reached a peak from zero of 0.8 ms and the duty ratio of 1:1, the electrochemical roughening treatment was performed using a carbon electrode as a counter electrode. As an auxiliary anode, ferrite was used.

The current density was 25 A/dm² as the peak current value, and the electric quantity (C/dm²) in the hydrochloric acid electrolysis was 63 C/dm² as the sum total of electric quantity at the time of anodization of the aluminum plate. Thereafter, washing with water by spraying was performed.

### (A-h) Alkali etching treatment

The aluminum plate obtained above was subjected to an etching treatment by spraying a caustic soda aqueous solution in which the concentration of caustic soda was 5 mass% and the concentration of aluminum ions was 0.5 mass% using a spray tube at a temperature of 50°C. Thereafter, washing with water by spraying was performed. The amount of aluminum dissolved was 0.1 g/m².

### (A-i) Desmutting treatment in acidic aqueous solution

Next, a desmutting treatment was performed in a sulfuric acid aqueous solution. Specifically, the desmutting treatment was performed at a liquid temperature of 35°C for 4 seconds using the waste liquid (aluminum ions having a concentration of 5 g/L were dissolved in a sulfuric acid aqueous solution having a concentration of 170 g/L) generated in the anodization treatment step. The desmutting treatment was performed for 3 seconds by spraying the desmutting liquid using a spray.

### (A-j) Anodization treatment

An anodization treatment was performed using an anodization apparatus (the length of each of a first electrolytic portion and a second electrolytic portion was 6 m, the length of each of a first feeding portion and a second feeding portion was 3 m, and the length of each of a first feeding electrode and a second feeding electrode was 2.4 m) of a two-stage feeding electrolytic treatment method. As the electrolyte supplied to the first electrolytic portion and the second electrolytic portion, sulfuric acid was used. All electrolytes have a concentration of sulfuric acid of 50 g/L (including 0.5 mass% of aluminum ions) and were at a temperature of 20°C. Thereafter, washing with water by spraying was performed.

### (A-k) Silicate treatment

To ensure hydrophilicity of the non-image area, a silicate treatment was performed by dipping at 50°C for 7 seconds using 2.5 mass% No. 3 sodium silicate aqueous solution. The amount of Si attached was 10 mg/m². Thereafter, washing with water by spraying was performed.

### <Formation of undercoat layer>

The support prepared in the above-described manner was coated with an undercoat layer coating solution 1 described below, and the coating solution was dried at 80°C for 15 seconds to provide an undercoat layer, thereby preparing a support. The coating amount after drying was 15 mg/m².

### [Undercoat layer coating solution 1]

- Following copolymer having weight-average molecular weight of 28000: 0.3 parts
   (in the structural formulae, Et is ethyl, and each numerical value on the lower right side of parentheses indicates the molar ratio)
- Methanol: 100 parts
- Water: 1 part

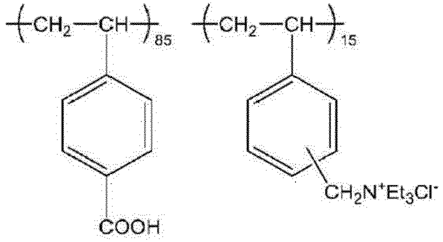

### <Formation of recording layer>

After the obtained support was coated with a coating solution composition (I) for forming a lower layer having the following composition using a wire bar, the resulting product was dried in a drying oven at 150°C for 40 seconds such that the coating amount thereof was set to 1.0 g/m², and thus a lower layer was provided. After the lower layer was provided, the lower layer was coated with a coating solution composition (II) for forming an upper layer having the following composition using a wire bar, whereby an upper layer was provided. After the coating, the resulting product was dried at 150°C for 40 seconds, whereby a planographic printing plate precursor in which the coating amount of the lower layer and the upper layer was 1.2 g/m² was obtained.

### [Coating solution composition (I) for forming lower layer]

- Polymer compound 1 and amounts listed in Tables 5 and 6
- Polymer compound 2-2 and amounts listed in Tables 5 and 6
- m,p-Cresol novolac (m/p ratio = 6/4, weight-average molecular weight of 6,000): 0.6 parts
- Infrared absorbent (IR coloring agent (1): following structure): 0.2 parts 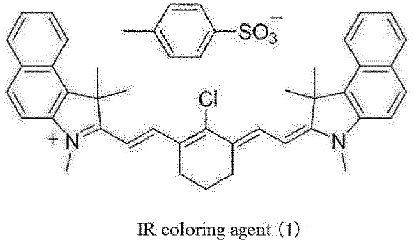
- 4,4'-Bishydroxyphenyl sulfone: 0.3 parts
- Tetrahydrophthalic acid: 0.4 parts
- p-Toluenesulfonic acid: 0.02 parts
- 3-Methoxy-4-diazodiphenylamine hexafluorophosphate: 0.06 parts
- Product obtained by replacing a counter ion of ethyl violet with 6-hydroxynaphthalenesulfonic acid: 0.15 parts
- Fluorine-based surfactant (MEGAFACE F-780, manufactured by DIC Corporation): 0.07 parts
- Methyl ethyl ketone: 30 parts
- 1-Methoxy-2-butyrolactone: 15 parts
- γ-Butyrolactone: 15 parts

### [Coating solution composition (II) for forming upper layer]

- Novolac resin (m-cresol/p-cresol/phenol = 3/2/5, Mw of 8,000): 0.68 parts
- Infrared absorbent (IR coloring agent (1): above structure): 0.045 parts
- Fluorine-based surfactant (MEGAFACE F-780, manufactured by DIC Corporation): 0.03 parts
- Methyl ethyl ketone: 15.0 parts
- 1-Methoxy-2-propanol: 30.0 parts
- 5-Benzoyl-4-hydroxy-2-methoxybenzenesulfonate of 1-(4-methylbenzyl)-1-phenyl piperidinium: 0.01 parts

The following evaluations were performed using the obtained planographic printing plate precursors, and the results are listed in Tables 5 and 6.

### <Evaluation of planographic printing plate precursor>

### [Evaluation of solubility resistance of image area and non-image area development time]

Drawing of a test pattern in an image was performed on each positive type planographic printing plate precursor of each example and each comparative example using a Trendsetter VX (manufactured by Creo Company) at a beam intensity of 9 W and a drum rotation speed of 150 rpm.

Thereafter, the resulting product was immersed in a developing bath charged with a developer XP-D (which was made to have a conductivity of 43 mS/cm by dilution) (manufactured by Fujifilm Corporation), and the time taken until the dissolution of the image area was started at a development temperature of 30°C and the time required for developing the non-image area were measured.

The time taken until the dissolution of the image area was started was set as the time taken until the measured value of the optical density (OD value) in the image area was decreased by 0.05 from the measured value of the optical density in the image area before the development treatment. Further, the immersion time at which a difference between the measured value of the optical density in the non-image area and the measured value of the optical density of the Al support reached 0.02 or less was set as the non-image area development time. In both cases, the optical density was measured using a spectrophotometer SpectroEye (manufactured by GretagMacbeth Company).

As the time until the dissolution of the image area is started is longer, the resistance to an alkali aqueous solution is excellent. Further, as the non-image area development time is shorter, the solubility of the non-image area in an alkali aqueous solution is excellent and an alkali aqueous solution developability (highlight reproducibility) is good. Accordingly, it is evaluated that the positive type planographic printing plate precursor has excellent developability in a case where the image area dissolution starting time is long, the non-image area development time is short, and the difference between the image area dissolution starting time and the non-image area development time is large. The results are listed in Tables 5 and 6.

### [Evaluation of printing durability]

Drawing of a test pattern in an image was performed on each positive type planographic printing plate precursor of each example and each comparative example using a Trendsetter (manufactured by Creo company) at a beam intensity of 9 W and a drum rotation speed of 150 rpm. Thereafter, using PS PROCESSOR LP940H (manufactured by Fujifilm Corporation) charged with a developer XP-D (which was made to have a conductivity of 43 mS/cm by dilution) (manufactured by Fujifilm Corporation), development was performed at a developing temperature of 30°C for the development time which was the non-image area development time listed in Tables 5 and 6. This was continuously printed using a printing machine LITHRONE (manufactured by KOMORI Corporation). As the ink, a tokunen black ink (manufactured by TOYO INK CO., LTD.) containing calcium carbonate was used as a model of a low-grade material. At this time, by visually measuring how many sheets could be printed while maintaining a sufficient ink density, the printing durability was evaluated. It was evaluated that the printing durability was excellent as the number of sheets was larger. The results are listed in Tables 5 and 6.

### [Evaluation of chemical resistance]

Exposure, development, and printing were performed on each positive type planographic printing plate precursor of each example and each comparative example in the same manner as in the evaluation of the printing durability. In this time, every time 5,000 sheets were printed, a step of wiping the plate surface with a cleaner (manufactured by Fujifilm Corporation, multi cleaner) was performed, and the chemical resistance was evaluated. The printing durability at this time was evaluated as 1 in a case where the number of printed sheets was 95-100% of the number of printing endurable sheets described above, evaluated as 2 in a case where the number of printed sheets was 80 to less than 95%, evaluated as 3 in a case where the number of printed sheets was 60 to less than 80%, and evaluated as 4 in a case where the number of printed sheets was < 60%. Even in a case where the step of wiping the plate surface with a cleaner was performed, as the change in the printing durability index was smaller, the chemical resistance was evaluated to be excellent. The results are listed in Tables 5 and 6.

### [Exposed portion development time after lapse of time from exposure]

Drawing of a test pattern in an image was performed on each positive type planographic printing plate precursor of each example and each comparative example using a Trendsetter (trade name, manufactured by Creo Company) at a beam intensity of 9 W and a drum rotation speed of 150 rpm. Thereafter, the resulting product was allowed to stand at room temperature (25°C) and a humidity of 60% for 50 minutes and immersed in a developing bath charged with a developer DT-2 (trade name, manufactured by Fujifilm Corporation) (which was made to have a conductivity of 43 mS/cm by dilution), and the time required for developing the non-image area at a development temperature of 30°C was measured. Further, the immersion time at which a difference between the measured value of the optical density in the non-image area and the measured value of the optical density of the Al support reached ≤ 0.02 was set as the exposed portion development time. In the development carried out for a shorter time than the exposed portion development time, stains were generated on the printed material. The optical density was measured using a spectrophotometer SpectroEye (manufactured by GretagMacbeth Company). The evaluation results are listed in Tables 5 and 6.

**[Table 5]**

| | Polymer compound 1 | Content of polymer compound 1 | Polymer compound 2-2 | Content of polymer compound 2-2 | Evaluation results | | | | |
|---|---|---|---|---|---|---|---|---|---|
| | | | | | Non-image area developme nt time (sec) | Image area dissolution starting time (sec) | Printing durability Number of printed sheets (10000 sheets) | Non-image area development time after lapse of time from exposure (sec) | Chemical resistance |
| Example 1 | PU-1 | 2.0 parts | PE-1 | 1.5 parts | 11 | 31 | 14 | 11 | 1 |
| Example 2 | PU-1 | 1.5 parts | PE-1 | 2.0 parts | 12 | 32 | 14 | 12 | 2 |
| Example 3 | PU-1 | 1.0 parts | PE-1 | 2.5 parts | 12 | 31 | 14 | 12 | 1 |
| Example 4 | PU-1 | 2.5 parts | PE-6 | 1.0 parts | 12 | 31 | 15 | 13 | 1 |
| Example 5 | PU-1 | 2.5 parts | PE-12 | 1.0 parts | 11 | 30 | 14 | 12 | 1 |
| Example 6 | PU-1 | 2.5 parts | PE-14 | 1.0 parts | 12 | 30 | 14 | 13 | 1 |
| Example 7 | PU-1 | 2.5 parts | PE-15 | 1.0 parts | 13 | 31 | 14 | 14 | 1 |
| Example 8 | PU-1 | 2.5 parts | PE-16 | 1.0 parts | 12 | 31 | 14 | 13 | 1 |
| Example 9 | PU-1 | 2.5 parts | PE-17 | 1.0 parts | 13 | 31 | 14 | 14 | 1 |
| Example 10 | PU-1 | 2.5 parts | PE-18 | 1.0 parts | 12 | 32 | 14 | 13 | 1 |
| Example 11 | PU-1 | 2.5 parts | PE-19 | 1.0 parts | 12 | 30 | 14 | 12 | 2 |
| Example 12 | PU-8 | 2.5 parts | PE-1 | 1.0 parts | 12 | 30 | 15 | 12 | 1 |
| Example 13 | PU-14 | 2.5 parts | PE-1 | 1.0 parts | 13 | 30 | 15 | 14 | 1 |
| Example 14 | PU-15 | 2.5 parts | PE-1 | 1.0 parts | 12 | 31 | 15 | 13 | 1 |
| Example 15 | PU-17 | 2.5 parts | PE-1 | 1.0 parts | 11 | 32 | 16 | 11 | 1 |
| Comparative Example 1 | CP-1 | 2.5 parts | PE-1 | 1.0 parts | 130 | 200 | 10 | 140 | 2 |
| Comparative Example 2 | - | - | PE-1 | 1.0 parts | 25 | 45 | 7 | 30 | 2 |

Further, the structure of CP-lused in Comparative Example 1 are as shown below. In the structure, each numerical value on the lower right side of parentheses indicates the molar ratio. CP-lwas synthesized with reference to the method described in WO 2016/133072.

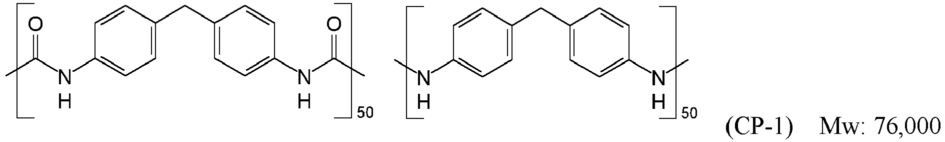

**[Table 6]**

| | Polymer compound 1 | Content of polymer compound 1 | Polymer compound 2-2 | Content of polymer compound 2-2 | Evaluation results | | | | |
|---|---|---|---|---|---|---|---|---|---|
| | | | | | Non-image area development time (sec) | Image area dissolution starting time (sec) | Printing durability Number of printed sheets (10000 sheets) | Non-image area development time after lapse of time from exposure (sec) | Chemical resistance |
| Example 16 | PT-1 | 2.0 parts | PE-1 | 1.5 parts | 10 | 30 | 13 | 10 | 1 |
| Example 17 | PT-1 | 1.5 parts | PE-1 | 2.0 parts | 10 | 31 | 13 | 10 | 2 |
| Example 18 | PT-1 | 1.0 parts | PE-1 | 2.5 parts | 11 | 31 | 13 | 12 | 1 |
| Example 19 | PT-1 | 2.5 parts | PE-6 | 1.0 parts | 11 | 30 | 14 | 12 | 1 |
| Example 20 | PT-1 | 2.5 parts | PE-12 | 1.0 parts | 10 | 30 | 13 | 11 | 1 |
| Example 21 | PT-1 | 2.5 parts | PE-14 | 1.0 parts | 11 | 30 | 13 | 11 | 1 |
| Example 22 | PT-1 | 2.5 parts | PE-15 | 1.0 parts | 12 | 31 | 13 | 13 | 1 |
| Example 23 | PT-1 | 2.5 parts | PE-16 | 1.0 parts | 11 | 31 | 13 | 11 | 1 |
| Example 24 | PT-1 | 2.5 parts | PE-17 | 1.0 parts | 12 | 31 | 13 | 13 | 1 |
| Example 25 | PT-1 | 2.5 parts | PE-18 | 1.0 parts | 12 | 32 | 13 | 13 | 1 |
| Example 26 | PT-1 | 2.5 parts | PE-19 | 1.0 parts | 11 | 30 | 13 | 12 | 2 |
| Example 26 | PT-13 | 2.5 parts | PE-1 | 1.0 parts | 10 | 33 | 15 | 11 | 1 |
| Example 28 | PT-14 | 2.5 parts | PE-1 | 1.0 parts | 12 | 30 | 15 | 12 | 1 |
| Example 29 | PT-15 | 2.5 parts | PE-1 | 1.0 parts | 11 | 31 | 15 | 12 | 1 |
| Example 30 | PT-16 | 2.5 parts | PE-1 | 1.0 parts | 12 | 32 | 16 | 13 | 1 |
| Example 31 | PC-1 | 2.0 parts | PE-1 | 1.5 parts | 10 | 29 | 11 | 10 | 1 |
| Example 32 | PC-1 | 1.5 parts | PE-1 | 2.0 parts | 10 | 30 | 12 | 11 | 2 |
| Example 33 | PC-1 | 1.0 parts | PE-1 | 2.5 parts | 11 | 30 | 12 | 12 | 1 |
| Example 34 | PC-1 | 2.5 parts | PE-6 | 1.0 parts | 11 | 29 | 13 | 12 | 1 |
| Example 35 | PC-1 | 2.5 parts | PE-12 | 1.0 parts | 10 | 29 | 12 | 10 | 2 |
| Example 36 | PC-1 | 2.5 parts | PE-14 | 1.0 parts | 11 | 30 | 12 | 11 | 1 |
| Example 36 | PC-1 | 2.5 parts | PE-15 | 1.0 parts | 12 | 30 | 12 | 13 | 2 |
| Example 38 | PC-1 | 2.5 parts | PE-16 | 1.0 parts | 11 | 30 | 12 | 11 | 1 |
| Example 39 | PC-1 | 2.5 parts | PE-17 | 1.0 parts | 12 | 30 | 11 | 12 | 1 |
| Example 40 | PC-1 | 2.5 parts | PE-18 | 1.0 parts | 12 | 31 | 12 | 12 | 2 |
| Example 41 | PC-1 | 2.5 parts | PE-19 | 1.0 parts | 11 | 30 | 12 | 12 | 2 |
| Example 42 | PT-7 | 2.5 parts | PE-1 | 1.0 parts | 10 | 30 | 13 | 11 | 1 |
| Example 43 | PT-8 | 2.5 parts | PE-1 | 1.0 parts | 12 | 29 | 13 | 12 | 1 |
| Example 44 | PT-10 | 2.5 parts | PE-1 | 1.0 parts | 11 | 30 | 13 | 12 | 1 |
| Example 45 | PT-12 | 2.5 parts | PE-1 | 1.0 parts | 11 | 31 | 15 | 12 | 1 |

As shown in the results listed in Tables 5 and 6, it was found that the printing plate precursor has excellent developability, printing durability, and temporal stability after exposure.

## Claims

1. A printing plate precursor, which is a positive type planographic printing plate precursor, comprising:
(i) a support which has a hydrophilic surface and, on the support,
(ii) an image recording layer comprising:
- a polymer compound 1 comprising at least one bond selected from a urea bond, a urethane bond, and a carbonate bond in a main chain and comprising a sulfonamide group in the main chain;
- a polymer compound 2-2 comprising a constitutional unit of Formula EV-1 and a constitutional unit of Formula EV-2: 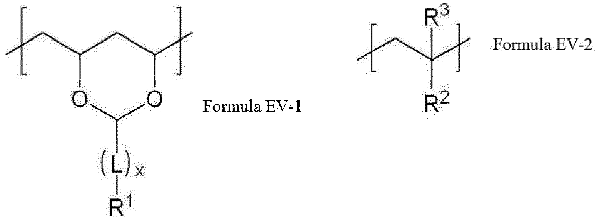 wherein L is a divalent linking group, X is 0 or 1, R¹ is an aromatic or heteroaromatic ring containing at least one hydroxy group, and R² and R³ each independently are H, halogen, an optionally substituted aromatic or heteroaromatic ring, or an optionally substituted linear, branched or cyclic alkyl or alkenyl group; and
- an infrared absorbent.

2. The printing plate precursor of claim 1, wherein the polymer compound 1 further comprises a polycyclic structure in the main chain.

3. The printing plate precursor of claim 1 or 2, wherein the polymer compound 1 comprises, as a constitutional unit comprising the sulfonamide group, a constitutional unit of Formula A-1 wherein R⁴ is a divalent linking group:

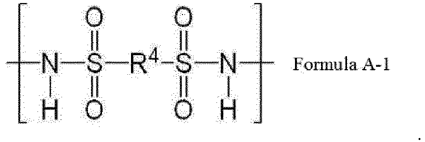

4. The printing plate precursor of claim 3, wherein the constitutional unit of Formula A-1 comprises a constitutional unit of any of the Formulae B1-1 to B1-6: 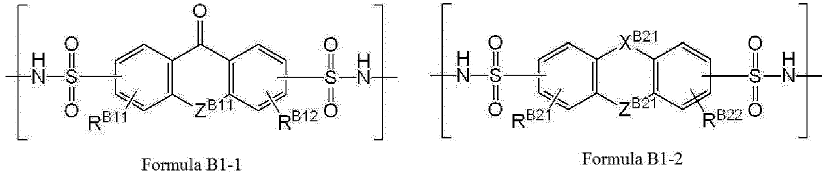 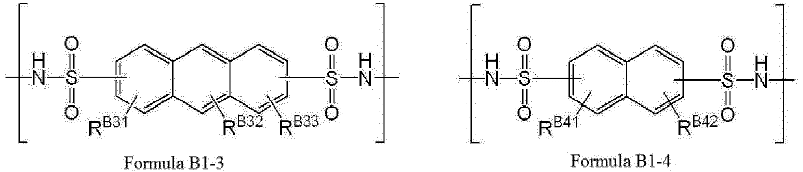 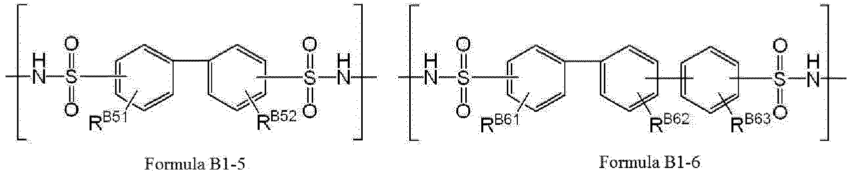 wherein R^{B11}, R^{B12}, R^{B21}, R^{B22}, R^{B31} to R^{B33}, R^{B41}, R^{B42}, R^{B51}, R^{B52}, and R^{B61}-R^{B63} each independently are H, a sulfonamide group, hydroxy, carboxy, alkyl or halogen, Z^{B11} is -C(R)₂-, -C(=O)-, -O-, -NR-, -S-, or a single bond, Z^{B21} is -C(R)₂-, -O-, -NR-, -S-, or a single bond, R each independently is H or alkyl, X^{B21} is -C(R')₂-, -O-, -NR'-, -S-, or a single bond, and of R' each independently is H or alkyl.

5. The printing plate precursor of claim 4, wherein the constitutional unit of Formula A-1 comprises a constitutional unit of Formula B1-1 or B1-2.

6. The printing plate precursor of any of claims 1-4, wherein the polymer compound 2-2 is represented by Formula VA: 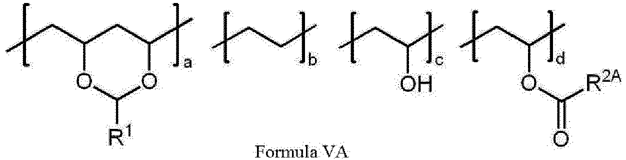 wherein R¹ is an aromatic or heteroaromatic ring containing at least one hydroxyl group, R^{2A} is optionally substituted alkyl, a represents 10-55 mol%, b represents 15-60 mol%, c represents 10-60 mol% and d represents 0-10 mol%.

7. The printing plate precursor of any of claims 1-6, comprising a recording layer comprising a lower layer and an upper layer in this order on the support having a hydrophilic surface, wherein at least one of the lower layer and the upper layer is the image recording layer.

8. The printing plate precursor of claim 7, wherein the lower layer is the image recording layer, and the upper layer is another recording layer.

9. The printing plate precursor of any of claims 1-8, further comprising an undercoat layer which is provided between the support having a hydrophilic surface and the image recording layer.

10. A method of producing a planographic printing plate, comprising image-wise light exposing the printing plate precursor of any of claims 1-9; and developing the exposed printing plate precursor using an alkali aqueous solution having a pH of 8.5-13.5.

## Patentansprüche

1. Druckplattenvorläufer, der ein Flachdruckplattenvorläufer vom Positivtyp ist, umfassend:
(i) einen Träger, der eine hydrophile Oberfläche aufweist, und auf dem Träger
(ii) eine Bildaufzeichnungsschicht, umfassend:
- eine Polymerverbindung 1, umfassend in einer Hauptkette zumindest eine Bindung, ausgewählt aus einer Harnstoffbindung, einer Urethanbindung und einer Carbonatbindung, und umfassend in der Hauptkette eine Sulfonamidgruppe,
- eine Polymerverbindung 2-2, umfassend eine Aufbaueinheit der Formel EV-1 und eine Aufbaueinheit der Formel EV-2: 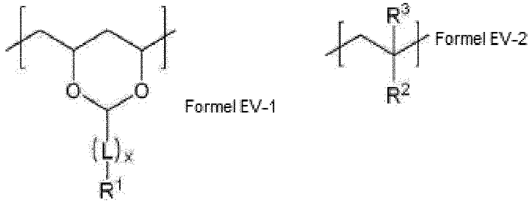 worin L eine divalente Verknüpfungsgruppe ist, X 0 oder 1 ist, R¹ ein aromatischer oder heteroaromatischer Ring, enthaltend mindestens eine Hydroxygruppe, ist, und R² und R³ jeweils unabhängig H, Halogen, ein optional substituierter aromatischer oder heteroaromatischer Ring oder eine optional substituierte, lineare, verzweigte oder cyclische Alkyl- oder Alkenylgruppe sind; und
- einen Infrarotabsorber.

2. Druckplattenvorläufer gemäß Anspruch 1, worin die Polymerverbindung 1 in der Hauptkette ferner eine polycyclische Struktur umfasst.

3. Druckplattenvorläufer gemäß Anspruch 1 oder 2, worin die Polymerverbindung 1 als eine Aufbaueinheit, die die Sulfonamidgruppe umfasst, eine Aufbaueinheit der Formel A-1 umfasst, worin R⁴ eine divalente Verknüpfungsgruppe ist:

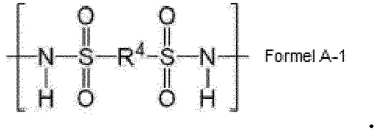

4. Druckplattenvorläufer gemäß Anspruch 3, worin die Aufbaueinheit der Formel A-1 eine Aufbaueinheit gemäß irgendeiner der Formeln B1-1 bis B1-6 umfasst: 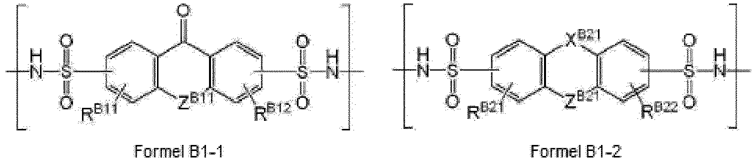 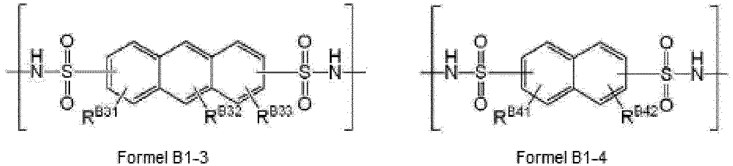 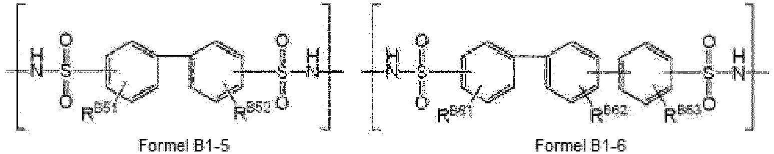 worin R^{B11}, R^{B12}, R^{B21}, R^{B22}, R^{B31} bis R^{B33}, R^{B41}, R^{B42}, R^{B51}, R^{B52} und R^{B61}-R^{B63} jeweils unabhängig H, eine Sulfonamidgruppe, Hydroxy, Carboxy, Alkyl oder Halogen sind, Z^{B11} -C(R)₂-, -C(=O)-, -O-, -NR-, -S- oder eine Einfachbindung ist, Z^{B21} -C(R)₂-_{'} -O-, -NR-, -S- oder eine Einfachbindung ist, R jeweils unabhängig H oder Alkyl ist, X^{B21} -C(R')₂-, -O-, -NR'-, -S- oder eine Einfachbindung ist, und jedes R' unabhängig H oder Alkyl ist.

5. Druckplattenvorläufer gemäß Anspruch 4, worin die Aufbaueinheit der Formel A-1 eine Aufbaueinheit der Formel B1-1 oder B1-2 umfasst.

6. Druckplattenvorläufer gemäß irgendeinem der Ansprüche 1-4, worin die Polymerverbindung 2-2 durch die Formel AV dargestellt wird: 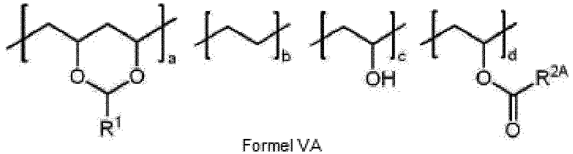 worin R¹ ein aromatischer oder heteroaromatischer Ring, enthaltend mindestens eine Hydroxylgruppe, ist, R^{2A} ein gegebenenfalls substituiertes Alkyl ist, a 10-55 mol-% darstellt, b 15-60 mol-% darstellt, c 10-60 mol-% darstellt und d 0-10 mol-% darstellt.

7. Druckplattenvorläufer gemäß irgendeinem der Ansprüche 1-6, umfassend eine Aufzeichnungsschicht, die in dieser Reihenfolge auf dem Träger, der eine hydrophile Oberfläche aufweist, eine untere Schicht und eine obere Schicht umfasst, worin mindestens eine von der unteren Schicht und der oberen Schicht die Bildaufzeichnungsschicht ist.

8. Druckplattenvorläufer gemäß Anspruch 7, worin die untere Schicht die Bildaufzeichnungsschicht ist und die obere Schicht eine andere Aufzeichnungsschicht ist.

9. Druckplattenvorläufer gemäß irgendeinem der Ansprüche 1-8, ferner umfassend eine Unterzugsschicht, die zwischen dem Träger, der eine hydrophile Oberfläche aufweist, und der Bildaufzeichnungsschicht vorgesehen ist.

10. Verfahren zur Herstellung einer Flachdruckplatte, umfassend das bildweise Belichten des Druckplattenvorläufers gemäß irgendeinem der Ansprüche 1-9; und das Entwickeln des belichteten Druckplattenvorläufers unter Verwendung einer wässrigen Alkalilösung mit einem pH-Wert von 8,5-13,5.

## Revendications

1. Précurseur de plaque d'impression, qui est un précurseur de plaque d'impression planographique de type positif, comprenant :
(i) un support qui présente une surface hydrophile et, sur le support,
(ii) une couche d'enregistrement d'image comprenant :
- un composé polymère 1 comprenant au moins une liaison sélectionnée parmi une liaison urée, une liaison uréthane, et une liaison carbonate dans une chaîne principale et comprenant un groupe sulfonamide dans la chaîne principale ;
- un composé polymère 2-2 comprenant un motif constitutif de Formule EV-1 et un motif constitutif de Formule EV-2 : 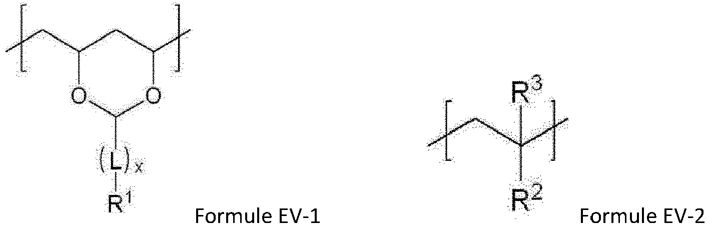 dans lequel L est un groupe de liaison divalent, X est 0 ou 1, R¹ est un cycle aromatique ou hétéroaromatique contenant au moins un groupe hydroxy, et R² et R³ sont chacun indépendamment H, halogène, un cycle aromatique ou hétéroaromatique éventuellement substitué, ou un groupe alkyle ou alcényle linéaire, ramifié ou cyclique éventuellement substitué ; et
- un absorbant de rayonnement infrarouge.

2. Précurseur de plaque d'impression selon la revendication 1, dans lequel le composé polymère 1 comprend en outre une structure polycyclique dans la chaîne principale.

3. Précurseur de plaque d'impression selon la revendication 1 ou 2, dans lequel le composé polymère 1 comprend, en tant que motif constitutif comprenant le groupe sulfonamide, un motif constitutif de Formule A-1 dans lequel R⁴ est un groupe de liaison divalent :

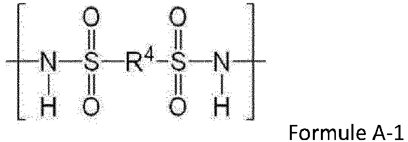

4. Précurseur de plaque d'impression selon la revendication 3, dans lequel le motif constitutif de Formule A-1 comprend un motif constitutif de l'une quelconque des Formules B1-1 à B1-6 : 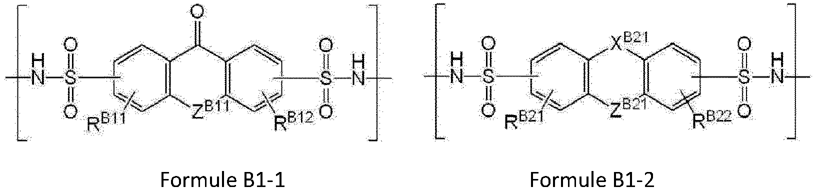 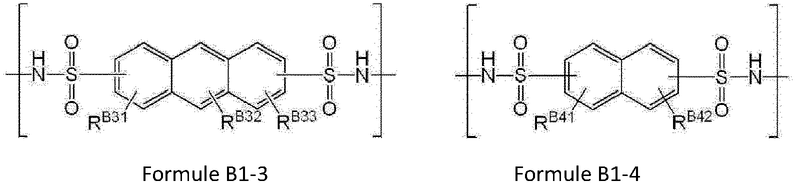 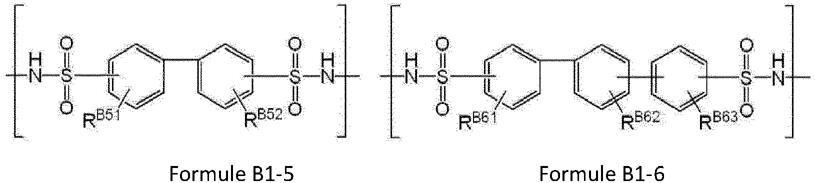 dans lequel R^{B11}, R^{B12}, R^{B21}, R^{B22}, R^{B31} à R^{B33}, R^{B41}, R^{B42}, R^{B51}, R^{B52}, et R^{B61}-R^{B63} sont chacun indépendamment H, un groupe sulfonamide, hydroxy, carboxy, alkyle ou halogène, Z^{B11} est -C(R)₂-, -C(=O)-, -O-, -NR-, -S-, ou une liaison simple, Z^{B21} est -C(R)₂-, -O-, -NR-, -S-, ou une liaison simple, chaque R est indépendamment H ou alkyle, X^{B21} est - C(R')₂-, -O-, -NR'-, -S-, ou une liaison simple, et chaque R' est indépendamment H ou alkyle.

5. Précurseur de plaque d'impression selon la revendication 4, dans lequel le motif constitutif de Formule A-1 comprend un motif constitutif de Formule B1-1 ou Bl-2.

6. Précurseur de plaque d'impression selon l'une quelconque des revendications 1-4, dans lequel le composé polymère 2-2 est représenté par la Formule VA : 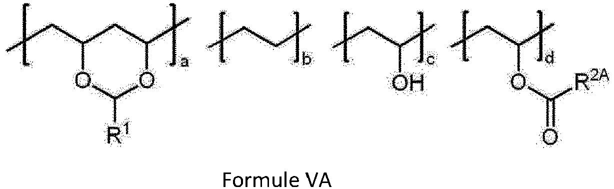 dans lequel R¹ est un cycle aromatique ou hétéroaromatique contenant au moins un groupe hydroxyle, R^{2A} est un alkyle éventuellement substitué, a représente 10-55 % en moles, b représente 15-60 % en moles, c représente 10-60% en moles et d représente O-10 % en moles.

7. Précurseur de plaque d'impression selon l'une quelconque des revendications 1-6, comprenant une couche d'enregistrement comprenant une couche inférieure et une couche supérieure, dans cet ordre, sur le support présentant une surface hydrophile, dans lequel au moins l'une parmi la couche inférieure et la couche supérieure est la couche d'enregistrement d'image.

8. Précurseur de plaque d'impression selon la revendication 7, dans lequel la couche inférieure est la couche d'enregistrement d'image, et la couche supérieure est une autre couche d'enregistrement.

9. Précurseur de plaque d'impression selon l'une quelconque des revendications 1-8, comprenant en outre une sous-couche qui est fournie entre le support présentant une surface hydrophile et la couche d'enregistrement d'image.

10. Procédé de production d'une plaque d'impression planographique, comprenant une exposition à une lumière selon l'image du précurseur de plaque d'impression selon l'une quelconque des revendications 1-9 ; et un développement du précurseur de plaque d'impression exposé en utilisant une solution aqueuse alcaline présentant un pH de 8,5-13,5.
